# EUROPEAN PATENT SPECIFICATION

(11) **EP 4 585 830 B1**
(45) Date of publication and mention of the grant of the patent: **02.09.2026**
(21) Application number: 24189263.7
(22) Date of filing: 17.07.2024
(51) Int. Cl.: F16H 55/08, B23F 11/00, B23F 13/00, F16H 55/22, G06F 30/17, G06F 30/20, G06N 7/00

(54) **ACTIVE DETERMINATION METHOD AND PRECISION MACHINING METHOD FOR HYDRODYNAMIC OIL FILM WORM-GEAR PAIR**
AKTIVES BESTIMMUNGSVERFAHREN UND PRÄZISIONSBEARBEITUNGSVERFAHREN FÜR HYDRODYNAMISCHES ÖLFILMSCHNECKENPAAR
PROCÉDÉ DE DÉTERMINATION ACTIVE ET PROCÉDÉ D'USINAGE DE PRÉCISION POUR UNE PAIRE DE VIS SANS FIN À FILM D'HUILE HYDRODYNAMIQUE

(30) Priority: 11.01.2024 CN 202410047634
(43) Date of publication of application: 16.07.2025
(73) Proprietor: Chongqing University, Shapingba, Chongqing 400044 (CN)
(72) Inventor: WANG, Shilong, Chongqing, 400044 (CN); WANG, Sibao, Chongqing, 400044 (CN); XIAO, Yuliang, Chongqing, 400044 (CN); DONG, Jianpeng, Chongqing, 400044 (CN); MA, Wensheng, Chongqing, 400044 (CN); KANG, Ling, Chongqing, 400044 (CN); YANG, Bo, Chongqing, 400044 (CN); YI, Lili, Chongqing, 400044 (CN); YU, Chunjian, Chongqing, 400044 (CN); ZHANG, Hu, Chongqing, 400044 (CN); JIANG, Lin, Chongqing, 400044 (CN); YANG, Canhui, Chongqing, 400044 (CN)
(74) Representative: M. Zardi & Co S.A.

(56) References cited:
- CN-A- 106 874 596
- HUANG GENG ET AL: "Thermal Elastohydrodynamic Lubrication Analysis for Rolling Cone Enveloping End Face Worm Drive", JOURNAL OF PHYSICS: CONFERENCE SERIES, IOP PUBLISHING, BRISTOL, GB, vol. 2459, no. 1, 1 March 2023 (2023-03-01), XP020447712, ISSN: 1742-6588, [retrieved on 20230301], DOI: 10.1088/1742-6596/2459/1/012105
- SIMON VILMOS V ED - DAI JIAN S ET AL: "Multi-objective optimization of hypoid gears to improve operating characteristics", MECHANISM AND MACHINE THEORY, PERGAMON, AMSTERDAM, NL, vol. 146, 17 December 2019 (2019-12-17), XP086006210, ISSN: 0094-114X, [retrieved on 20191217], DOI: 10.1016/J.MECHMACHTHEORY.2019.103727

## Description

### TECHNICAL FIELD

The present invention relates to the field of design and machining of worm-gear pairs, and in particular, to an active determination method and a precision machining method for a hydrodynamic oil film worm-gear pair.

### BACKGROUND

The worm-gear pair is a key component for transmitting motion and power, with advantages such as large transmission ratio and self-locking. It is widely used in high-end Computer Numerical Control (CNC) machine tools, large astronomical telescopes, and other major equipment, directly determining the operational performance of the equipment. Due to the relative sliding motion of the tooth surfaces of the worm-gear pair, there is significant frictional resistance. Additionally, to reduce tooth surface adhesion, the worm is made of copper alloy, which has poor wear resistance. This leads to low transmission efficiency, poor load-bearing capacity, severe vibration, high noise, and poor accuracy retention of the worm-gear pair. The existing method mainly involves simple modification of the worm and worm gear to increase the contact area and avoid eccentric loading, improving the meshing performance of the worm-gear pair. However, it cannot fundamentally improve the meshing performance.

Moreover, the tooth surface design method results in complex modified surfaces for the worm-gear pair, leading to extremely difficult machining. Because the worm gear is made of copper alloy, which is soft and cannot be ground, it can only be cut by hobbing. Hobbing is a generating process. Therefore, the cutting trace is fixed in the enveloping process. Existing enveloping processes can only remove more material from the vicinity of both ends of the worm gear by slightly advancing the hob along the axial direction of the worm gear, which only qualitatively achieves removal of more tooth surface material. Therefore, it is difficult to achieve precise control of the modification trajectory, which cannot ensure the accurate creation of the designed opening profile and surface macro-micro parameters, thus failing to meet practical needs.

In HUANG GENG ET AL ("Thermal Elastohydrodynamic Lubrication Analysis for Rolling Cone Enveloping End Face Worm Drive", JOURNAL OF PHYSICS: CONFERENCE SERIES, IOP PUBLISHING, BRISTOL, GB,vol. 2459, no. 1, 1 March 2023 (2023-03-01), XP020447712, ISSN: 1742-6588, DOl: 10.1088/1742-6596/2459/1/012105), on which the two part form of claim 1 is based, methods are explained to explore the thermal elastohydrodynamic lubrication performance of rolling cone enveloping end face worm drive, the mathematical model of thermal elastohydrodynamic lubrication is established based on the meshing theory of rolling cone enveloping end face worm drive and elastohydrodynamic lubrication theory. With the help of the numerical analysis software MATLAB, the thermal elastohydrodynamic lubrication performance under smooth conditions is selectively analyzed by the multigrid method. Besides, the effects of throat coefficient, cone apex radius and half cone angle of the rolling cone on thermal elastohydrodynamic lubrication performance are analyzed at the meshing out of the transmission pair. The results show that the thermal elastohydrodynamic lubrication film thickness at meshing out of the worm gear is the smallest; the oil film thickness, oil film pressure and oil film temperature are reduced from meshing in to meshing out. The oil film temperature at the interlayer is the largest. The oil film temperature at the end face worm surface is the smallest. The small half-cone angle of the cone apex radius and larger throat coefficient and cone apex radius may achieve better thermal elastohydrodynamic lubrication performance of rolling cone enveloping end face worm drive.

In SIMON VILMOS V ED - DAI JIAN S ET AL ("Multi-objective optimization of hypoid gears to improve operating characteristics", MECHANISM AND MACHINE THEORY, PERGAMON, AMSTERDAM, NL, vol. 146, 17 December 2019 (2019-12-17), XP086006210,ISSN: 0094-114X, DOI: 10.1016/J.MECHMACHTHEORY.2019.103727), a multi-objective optimization method of hypoid gears correlating to the operating characteristics is presented. Optimal design of hypoid gears demands that multiple objectives be simultaneously achieved. Four objectives considered in this study are the minimization of the maximum tooth contact pressure, transmission error and the average temperature in the gear mesh, and the maximization of the mechanical efficiency of the gear pair. The goals of the optimization are achieved by the optimal modification of meshing teeth surfaces. In practice, these modifications are introduced by applying the appropriate machine tool setting for the manufacture of the pinion and the gear, and/or by using a tool with an optimized profile. The proposed optimization procedure relies heavily on the loaded tooth contact analysis for the prediction of tooth contact pressure distribution and transmission errors, and on the mixed elastohydrodynamic analysis of lubrication to determine temperature and efficiency. A fast elitist nondominated sorting genetic algorithm (NSGA-II) is applied to solve the model. The effectiveness of the method is demonstrated by using hypoid gear examples. The obtained results have shown that by the optimization considerable improvements in the operating characteristics of the gear pair are achieved.

CN106874596 A discloses a precise modeling method of a Niemann worm wheel. The method comprises the steps that basic parameters of a worm of the worm wheel are set; an annular face equation of a sanding wheel is set up; a meshing equation of a worm of the sanding wheel is set up; a worm gear face equation is set up; a worm wheel worm meshing equation is set up; a coordinate formula of a contact point is obtained according to the worm gear face equation and the worm wheel worm meshing equation, and then a contact point set is obtained through a numerical method; the contact point set is guided into three-dimensional software to generate a worm wheel entity. The method has the advantages that point cloud is directly obtained through the numerical method, therefore, a smooth curve face of a worm wheel gear face is constructed, a good foundation is built for the worm wheel shape correction technology, and the thought can be used for modeling of other kinds of cylindrical worm pairs.

### SUMMARY

An active determination method for a hydrodynamic oil film worm-gear pair according to the present invention is claimed in claim 1.

A precision machining method for a hydrodynamic oil film worm-gear pair according to the present invention is claimed in claim 2.

An advantageous embodiment of the precision machining method is claimed in claim 3.

An objective of the present invention is to provide the active determination method and the precision machining method for a hydrodynamic oil film worm-gear pair, which can accurately design a worm-gear pair and achieve precise control of modification trajectories as well as precision machining of the worm-gear pair.

To achieve the above objective, the present invention provides the following technical solutions.

The active determination method for a hydrodynamic oil film worm-gear pair is provided, including:
establishing a precise three-dimensional digital model for a modification tooth surface of a worm-gear pair considering rough morphology;
proposing a cross-scale meshing contact analysis method for the worm-gear pair;
establishing a three-dimensional contact thermal elastohydrodynamic lubrication model for the worm-gear pair considering macro morphology, tooth surface roughness, and waviness of the modification tooth surface, and solving the model to obtain a friction coefficient, an oil film thickness, an oil film pressure, and a friction force;
with the friction coefficient, oil film thickness, oil film pressure, and friction force as objectives, determining an optimal worm-gear modification curve, worm tooth thickness distribution, pressure angle, helix angle, tooth surface roughness, and waviness for the hydrodynamic oil film based on an improved non-dominated sorting genetic algorithm II (NSGA-II) and principal component analysis (PCA); and
determining a hydrodynamic oil film worm-gear pair according to the optimal worm-gear modification curve, worm tooth thickness distribution, pressure angle, helix angle, tooth surface roughness, and waviness.

Wherein, said establishing the precise three-dimensional digital model for the modification tooth surface of the worm-gear pair considering rough morphology includes:
establishing a spatial coordinate system for an enveloping process of the worm-gear pair based on a principle of conjugate surface spatial meshing, deriving a worm tooth surface equation by using kinematic concepts and coordinate transformations, and deriving a worm gear tooth profile by using a point vector enveloping method, thereby obtaining a worm-gear tooth surface equation;
determining a probability density function by treating a rough surface as a random process and using an autocorrelation function in an exponential form; and based on the probability density function, representing a rough surface of the worm-gear pair using an amplitude and a phase angle component, to obtain a rough surface equation;
performing profile modification and axial modification based on the worm-gear tooth surface equation, to obtain a post-modification worm-gear tooth surface equation; and
obtaining a three-dimensional digital model of the worm-gear pair based on the post-modification worm-gear tooth surface equation and the rough surface equation.

Wherein, said performing profile modification and axial modification based on the worm-gear tooth surface equation to obtain the post-modification worm-gear tooth surface equation specifically includes:
determining a maximum modification amount by using the following formula: ${δ}_{Parabolic} = {Δ}_{max} {\left(\frac{x}{L}\right)}^{2}$, where *δ*_{Parabolic} represents a parabolic modification curve; Δₘₐₓ represents the maximum modification amount; *L* represents a total length of a double-tooth meshing zone; and *x* represents a distance from any point in the double-tooth meshing zone on a meshing line to a point of alternation between single and double teeth;
determining an inward offset of a tooth surface point after the axial modification compared to before the axial modification by using the following formula: ${e}_{M} = {r}_{c} - \sqrt{{r}_{c}^{2} - {\left({z}_{M}-Δe\right)}^{2}}$, where *e_{M}* is an inward offset before the axial modification;*r_{c}* is an addendum radius for involute teeth, and ${r}_{c} = \frac{{\left(0.5B\right)}^{2} + {{C}_{max}}^{2}}{2 {C}_{max}}$; *z_{M}* represents coordinates along a Z-axis direction for discrete points; Δ*e* is a deviation value between a midpoint of an addendum circle and a center of a gear; B is a tooth width; and *C*ₘₐₓ is a maximum addendum amount; and
determining the post-modification worm-gear tooth surface equation by using the following formula: $\vec{{r}_{fk}^{c}} = \left\{\begin{matrix}{{x}_{k}}^{c} \left({u}_{k}, {φ}_{k}\right) \\ {{y}_{k}}^{c} \left({u}_{k}, {φ}_{k}\right) \\ {{z}_{k}}^{c} \left({u}_{k}, {φ}_{k}\right) \\ 1\end{matrix}\right\} = \left\{\begin{matrix}{x}_{k} \left({u}_{k}, {φ}_{k}\right) + {e}_{MP} ⋅ cos \left({φ}_{{M}_{k}}\right) \\ {y}_{k} \left({u}_{k}, {φ}_{k}\right) + {e}_{MP} ⋅ sin \left({φ}_{{M}_{k}}\right) \\ {z}_{k} \left({u}_{k}, {φ}_{k}\right) \\ 1\end{matrix}\right\}$, where $\vec{{r}_{fk}^{c}}$ represents the post-modification tooth surface equation; *xₖ^{c}*, *yₖ^{c},* and *zₖ^{c}* represent x, y, and z coordinates of a post-modification tooth surface; *xₖ, yₖ,* and *zₖ* represent x, y, and z coordinates of a pre-modification tooth surface; *uₖ* represents an axial parameter of a tooth surface; *φₖ* represents an involute parameter during machining rotation; *e_{Mp}* represents an offset; and *φ_{Mk}* represents an angle of expansion of a tooth surface point.

Wherein, said obtaining the three-dimensional digital model of the worm-gear pair based on the post-modification worm-gear tooth surface equation and the rough surface equation specifically includes:
coupling the post-modification worm-gear tooth surface equation with the rough surface equation and solving a worm-gear tooth surface profile considering rough morphology and modification, thereby obtaining a discrete point set of the worm-gear tooth surface profile; and
creating a blank and inserting coordinate points of the discrete point set, to obtain a tooth surface curve; and based on the tooth surface curve, obtaining the three-dimensional digital model of the worm-gear pair considering rough morphology and modification.

Wherein, said proposing the cross-scale meshing contact analysis method for the worm-gear pair specifically includes:
deriving a contact point and a tooth surface clearance based on a tooth surface equation, and calculating a load distribution among teeth to obtain mechanical performance of tooth contact, where the tooth surface equation includes a post-modification tooth surface equation.

Wherein, said establishing the three-dimensional contact thermal elastohydrodynamic lubrication model for the worm-gear pair considering macro morphology, tooth surface roughness, and waviness of the modification tooth surface, and solving the model to obtain the friction coefficient, oil film thickness, oil film pressure, and friction force specifically includes:
an average Reynolds equation:
   $\frac{\partial }{\partial x} \left({∅}_{x}\frac{{h}^{3}}{12 μ}\frac{\partial \overline{p}}{\partial x}\right) + \frac{\partial }{\partial y} \left({∅}_{y}\frac{{h}^{3}}{12 μ}\frac{\partial \overline{p}}{\partial y}\right) = \frac{u}{2} {∅}_{c} \frac{\partial h}{\partial x} + \frac{u}{2} σ \frac{\partial {∅}_{s}}{\partial x}$, where *P̅* represents an average oil film pressure, *µ* represents a lubricating oil viscosity, *h* represents the oil film thickness, *u* represents an entrainment velocity, ∅*ₓ* represents a pressure flow factor in an x-direction, ∅*_{y}* represents a pressure flow factor in a y-direction, ∅*_{c}* represents a contact factor, and ∅*ₛ* represents a shear flow factor;
an oil film thickness equation *h*(*x, y*)*:*
   $h \left(x, y\right) = {h}_{0} + \frac{{x}^{2}}{2 {R}_{x}} + \frac{{y}^{2}}{2 {R}_{y}} + δ \left(x, y\right) + ν \left(x, y\right)$, where *Rₓ* and *R_{y}* represent equivalent radii of curvature, *E*' represents an equivalent elastic modulus, *h*₀ represents a constant that includes a membrane thickness at a rigid body center and a to-be-determined constant C, *δ*(*x, y*) represents equivalent roughness of two surfaces, and *v*(*x, y*) represents an elastic deformation;
a lubricating oil viscosity equation *µ* :
   $μ = {η}_{0} exp \left\{\left(ln {η}_{0}+9.67\right)\left[{\left(1+5.1\times {10}^{- 9}p\right)}^{z}-1\right]\right\}$, where *η*₀ represents a viscosity at atmospheric pressure, *z* represents a constant, $z = \frac{α}{5.1 \times {10}^{- 9} \left(ln {η}_{0}+9.67\right)}$, and *α* represents a viscosity-pressure coefficient;
a lubricating oil density equation *ρ*:
   $ρ = {ρ}_{0} \left(1+\frac{0.6 \times {10}^{- 9} p}{1 + 1.7 \times {10}^{- 9} p}\right)$, where *ρ*₀ represents a density at atmospheric pressure and temperature *T*₀;
a load balance equation *W*:
   *W =* ∬_{Ω}[*p*(*x, y*) *+ p_{c}*(*x, y*))]*dxdy*, where *p*(*x*, *y*) represents load per unit area on a lubricating film, *p_{c}*(*x, y*) represents load per unit area on surface asperities, and Ω represents an integration domain;
an entrainment velocity *v*:
   $ν = \frac{{ν}_{1 n} + {ν}_{2 n}}{2}$, where *v*_{1*n*} represents a component of a worm meshing point velocity along a normal direction to a contact line, and *v*_{2*n*} represents a component of a worm gear meshing point velocity along the normal direction to the contact line; and
a thermal correction coefficient *c_{T}* for the oil film thickness:
   ${c}_{T} = \frac{3.94}{3.94 + {L}^{0.62}} , L = \frac{{η}_{0} {βu}^{2}}{k}$, where *k* represents a thermal conductivity of the lubricating oil, and *β* represents a viscosity-temperature coefficient.

A precision machining method for a hydrodynamic oil film worm-gear pair, which is determined with the active determination method for a hydrodynamic oil film worm-gear pair, as described before, and implements precision machining of a worm gear tooth surface by using a double-lead variable-tooth-thickness hob, specifically includes:
determining a dual-lead variable-tooth-thickness hob, where the dual-lead variable-tooth-thickness hob includes a base hob face helix angle *γ*₁ and a variable-thickness hob face helix angle Y2, and different hob blade thicknesses are achieved by changing the helix angle;
machining using a standard hob blade thickness position of the dual-lead variable-tooth-thickness hob on a hobbing machine: by using a standard tooth thickness position, cutting the worm-gear pair according to a standard hobbing method until a hobbing margin of a tooth surface of the worm-gear pair is only a machining allowance of a last cut;
performing hob shifting with the dual-lead variable-tooth-thickness hob at a current radial feed position: advancing the dual-lead variable-tooth-thickness hob axially to cut using a dual-lead variable-tooth-thickness hob blade with a larger tooth thickness, where an axial shifting amount of the dual-lead variable-tooth-thickness hob is equal to a set value L;
retracting the dual-lead variable-tooth-thickness hob to a standard cutting thickness position; and
radially feeding the dual-lead variable-tooth-thickness hob to complete the last cut.

Wherein, the set value L is determined based on a single-side opening amount D.

Wherein, the set value L is determined using the following formula $L = \frac{Dl}{{qm}_{n} \left({tanγ}_{2}-{tanγ}_{1}\right)}$:
where *q* represents a hob pitch circle diameter factor, *mₙ* represents a normal modulus, *l* represents a minimum unit shifting amount, $l = \frac{{m}_{n} \times z \times π}{{cosγ}_{1} \times k}$*, z* represents the number of hob heads, and k represents the number of hob slots.

According to specific embodiments provided in the present invention, the present invention has the following technical effects:
In the active determination method and precision machining method for a hydrodynamic oil film worm-gear pair provided by the present invention, a three-dimensional digital model of a worm-gear pair considering rough morphology and modification is established, and an accurate model foundation is provided for subsequent lubrication simulation and optimization based on the three-dimensional digital model. A multi-objective optimization method for meshing performance, including friction coefficient, oil film thickness, oil film pressure, and friction force, is developed, and a worm-gear pair for hydrodynamic oil film meshing is formed, fundamentally improving meshing performance. In the design of tooth surface modification of the worm-gear pair, the present invention actively forms an open shape (wedge angle) at an engagement end and a disengagement end by actively modifying the tooth surface of the worm-gear pair, facilitating the entry of lubricating oil into an engagement area and forming a hydrodynamic oil film. The surface microstructure is optimized, which includes controlling a rough peak height of a rough-contact surface of the worm-gear pair, thus promoting an increase in the thickness of the hydrodynamic oil film to achieve full lubrication, thereby fundamentally improving the meshing performance.

### BRIEF DESCRIPTION OF THE DRAWINGS

To describe the technical solutions in embodiments of the present invention or in the prior art more clearly, the accompanying drawings required for the embodiments are briefly described below. Apparently, the accompanying drawings in the following description show merely some embodiments of the present invention, and those of ordinary skill in the art may still derive other accompanying drawings from these accompanying drawings without creative efforts.
FIG. 1 is a schematic diagram of an active determination method for a hydrodynamic oil film worm-gear pair according to the present invention;
FIG. 2 is a schematic diagram of a spatial coordinate system;
FIG. 3 is a schematic diagram of profile modification;
FIG. 4 is a schematic diagram of axial modification;
FIG. 5 is a schematic diagram illustrating improving NSGA-II using a local differential search method based on differential evolution;
FIG. 6 is a flowchart of principal component analysis; and
FIG. 7 is a schematic diagram of worm-gear pair machining.

### DETAILED DESCRIPTION OF THE EMBODIMENTS

The technical solutions of the embodiments of the present invention are clearly and completely described below with reference to the drawings in the embodiments of the present invention. Apparently, the described embodiments are merely a part rather than all of the embodiments of the present invention. All other embodiments obtained by those skilled in the art based on the embodiments of the present invention without creative efforts shall fall within the protection scope of the present invention.

An objective of the present invention is to provide an active determination method and a precision machining method for a hydrodynamic oil film worm-gear pair, which can accurately design a worm-gear pair and achieve precise control of modification trajectories as well as precision machining of the worm-gear pair.

In order to make the above objective, features and advantages of the present invention clearer and more comprehensible, the present invention will be further described in detail below in combination with accompanying drawings and particular implementation modes.

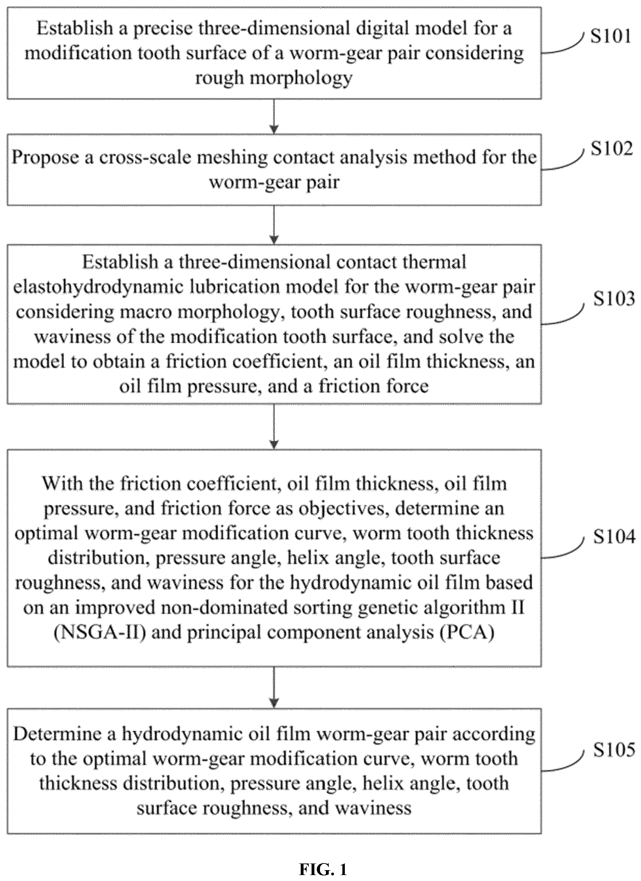

As shown in FIG. 1, an active determination method for a hydrodynamic oil film worm-gear pair provided in the present invention includes the following steps:
S101: Establish a precise three-dimensional digital model for a modification tooth surface of a worm-gear pair considering rough morphology.

S101 specifically includes the following sub-steps:
S110: Establish a spatial coordinate system for an enveloping process of the worm-gear pair based on a principle of conjugate surface spatial meshing, derive a worm tooth surface equation by using kinematic concepts and coordinate transformations, and derive a worm gear tooth profile by using a point vector enveloping method, thereby obtaining a worm-gear tooth surface equation.

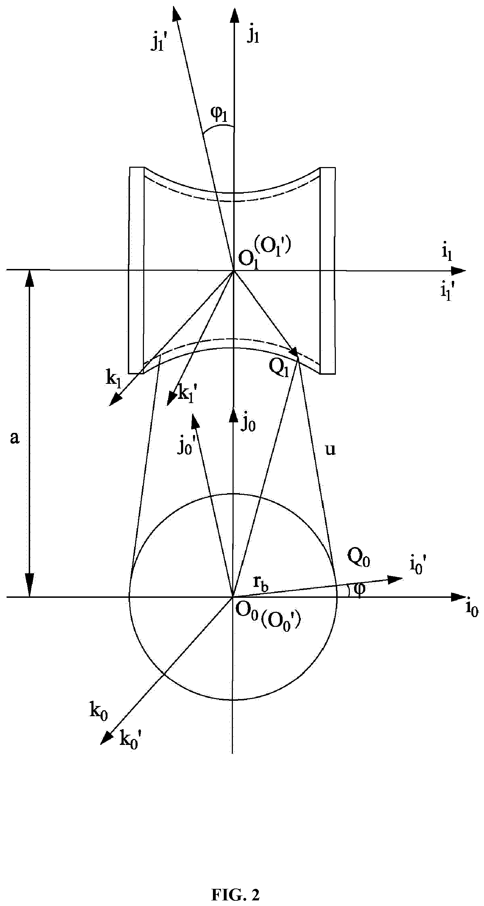

The spatial coordinate system is as shown in FIG. 2, and the worm tooth surface equation is provided as follows:
$\left(\begin{matrix}{x}_{1} \\ {y}_{1} \\ {z}_{1}\end{matrix}\right) = \left(\begin{matrix}{r}_{b} cos φ - u sin φ \\ \left({r}_{b}sinφ+ucosφ-a\right) {cosφ}_{1} \\ - \left({r}_{b}sinφ+ucosφ-a\right) {sinφ}_{1}\end{matrix}\right) ;$
where *r_{b}* represents a base circle radius of the worm gear; *u* represents a length from point *Q*₀ to point *Q*₁; Q₀ represents an intersection point of an ${i}_{0}^{′}$-axis of a moving coordinate system ${σ}_{0}^{′}$ with the base circle, a tangent is drawn through point Q₀ on the base circle, and Q₁ denotes any point on the tangent and in a middle area between a tooth top arc and a tooth root arc of the worm gear; *a* represents a distance between the i₀-axis and an i₁-axis, which is a center distance; *φ* represents an angle of rotation of the moving coordinate system ${σ}_{0}^{′} \left({O}_{0}^{′}; {X}_{0}^{′}; {Y}_{0}^{′}; {Z}_{0}^{′}\right)$ along a *k*₀-axis, and *φ*₁ represents an angle of rotation of a moving coordinate system ${σ}_{1}^{′} \left({O}_{1}^{′}; {X}_{1}^{′}; {Y}_{1}^{′}; {Z}_{1}^{′}\right)$ along the *i*₁-axis. By performing coordinate transformation the tooth surface equation for one side of the worm using an angle between initial envelopes on both sides, a tooth surface equation for the other side of the worm can be obtained.

For the process of deriving the worm gear tooth profile by using the point vector enveloping method, reference can be made to the patent entitled "Point Vector Double-Enveloping Method for Determining Machined Spiral Curved Surface Profile with Expanding Tool."

S111: Determine a probability density function by treating a rough surface as a random process and using an autocorrelation function in an exponential form; and based on the probability density function, represent a rough surface of the worm-gear pair using an amplitude and a phase angle component, to obtain a rough surface equation.

The process of establishing the rough surface equation includes treating a rough surface as a random process and using an autocorrelation function in an exponential form:
$R \left(x, y\right) = {σ}^{2} exp \left[-2.3{\left({x}^{2}/{{β}_{x}}^{2}+{y}^{2}/{{β}_{y}}^{2}\right)}^{1 / 2}\right] ;$
where σ represents a standard deviation of a rough surface height distribution; *βₓ* and *β_{y}* are autocorrelation lengths along *x* and *y* directions, respectively.

The probability density function *P_{k,l}* is solved by using the autocorrelation function:
${P}_{k , l} = \frac{1}{MN} {\sum }_{x = 0}^{M - 1} {\sum }_{y = 0}^{N - 1} R \left(x, y\right) exp \left[-i2π\left(kx/M+ly/N\right)\right] = \frac{1}{MN} FFT \left[R\left(x, y\right)\right] ;$
where M and N are the numbers of points generated in the x and y directions, respectively; i is an imaginary unit, and exp represents an exponential function with base e.

The rough surface of the worm-gear pair is represented using an amplitude and a phase angle component, to obtain the rough surface equation:
${z}_{p , q} = {\sum }_{k = 0}^{M - 1} {\sum }_{l = 0}^{N - 1} \sqrt{{P}_{k , l}} exp \left[{iφ}_{k , l}+i2π\left(kp/M+lq/N\right)\right] = IFFT \left(\sqrt{{P}_{k , l}} exp\left({iφ}_{k , l}\right)\right)$
where *p, q, k,* and *l* represent numbers ranging from 0 to *M-1; P_{k,l}* represents the probability density function; and *φ_{k,l}* represents the phase angle component of the rough surface.

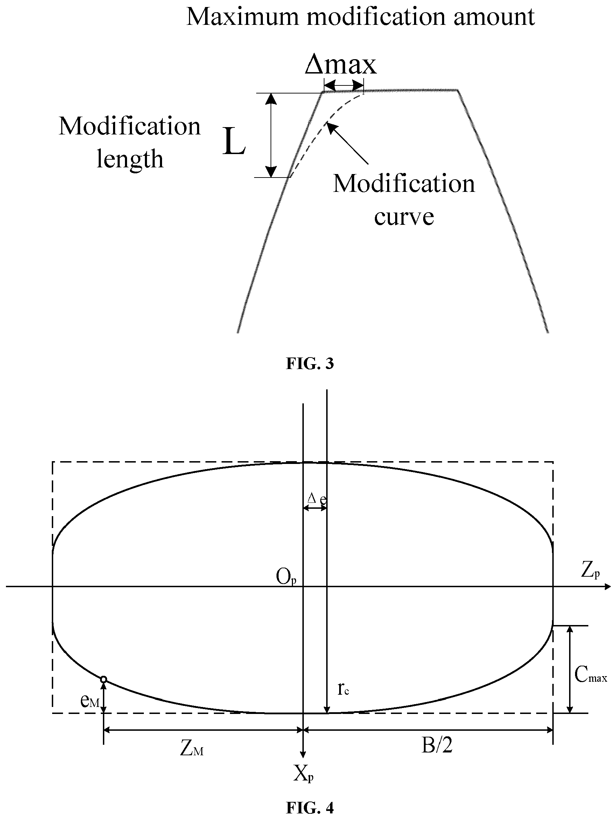

S112: Perform profile modification and axial modification based on the worm-gear tooth surface equation, to obtain a post-modification worm-gear tooth surface equation, where the profile modification and axial modification are as shown in FIG. 3 and FIG. 4, respectively.

The profile modification involves top profile modification, and modification parameters for the top profile modification include: a maximum modification amount, a modification length, and a modification curve. The maximum modification amount is calculated based on a maximum elastic deformation of the tooth profile under load. The modification length is divided into long modification and short modification. The modification curve is a parabola.

A maximum modification amount is determined by using the following formula: ${δ}_{Parabolic} = {Δ}_{max} {\left(\frac{x}{L}\right)}^{2}$, where *δ*_{Parabolic} represents a parabolic modification curve; Δₘₐₓ represents the maximum modification amount; *L* represents a total length of a double-tooth meshing zone; and *x* represents a distance from any point in the double-tooth meshing zone on a meshing line to a point of alternation between single and double teeth.

An inward offset of a tooth surface point after the axial modification compared to before the axial modification is determined by using the following formula: ${e}_{M} = {r}_{c} - \sqrt{{r}_{c}^{2} - {\left({z}_{M}-Δe\right)}^{2}}$, where *e_{M}* is an inward offset before the axial modification;*r_{c}* is an addendum radius for involute teeth, and ${r}_{c} = \frac{{\left(0.5B\right)}^{2} + {{C}_{max}}^{2}}{2 {C}_{max}}$; *z_{M}* represents coordinates along a Z-axis direction for discrete points; Δ*e* is a deviation value between a midpoint of an addendum circle and a center of a gear; B is a tooth width; and *C*ₘₐₓ is a maximum addendum amount.

According to the principle of tooth surface generation, the direction of the offset *e_{Mp}* is an involute that passes through a point on the tooth surface and is tangent to the base circle, and an expansion angle of the point is denoted as *φ_{Mk}.* In this case, *e_{Mp}* can be expressed in the gear coordinate system as follows:
${e}_{xp} = {e}_{MP} ⋅ cos \left({φ}_{Mk}\right) ;$
${e}_{yp} = {e}_{MP} ⋅ sin \left({φ}_{Mk}\right) ;$
where *eₓₚ* and *e_{yp}* are components of the offset *e_{Mp}* in the X and Y directions, respectively.

The post-modification worm-gear tooth surface equation is determined by using the following formula: $\vec{{r}_{fk}^{c}} = \left\{\begin{matrix}{{x}_{k}}^{c} \left({u}_{k}, {φ}_{k}\right) \\ {{y}_{k}}^{c} \left({u}_{k}, {φ}_{k}\right) \\ {{z}_{k}}^{c} \left({u}_{k}, {φ}_{k}\right) \\ 1\end{matrix}\right\} = \left\{\begin{matrix}{x}_{k} \left({u}_{k}, {φ}_{k}\right) + {e}_{MP} ⋅ cos \left({φ}_{{M}_{k}}\right) \\ {y}_{k} \left({u}_{k}, {φ}_{k}\right) + {e}_{MP} ⋅ sin \left({φ}_{{M}_{k}}\right) \\ {z}_{k} \left({u}_{k}, {φ}_{k}\right) \\ 1\end{matrix}\right\}$, where $\vec{{r}_{fk}^{c}}$ represents the post-modification tooth surface equation; *xₖ^{c}*, *yₖ^{c},* and *zₖ^{c}* represent x, y, and z coordinates of a post-modification tooth surface; *xₖ, yₖ,* and *zₖ* represent x, y, and z coordinates of a pre-modification tooth surface; *uₖ* represents an axial parameter of a tooth surface; *φₖ* represents an involute parameter during machining rotation; *e_{Mp}* represents an offset; and *φ_{Mk}* represents an angle of expansion of a tooth surface point.

S113: Obtain a three-dimensional digital model of the worm-gear pair based on the post-modification worm-gear tooth surface equation and the rough surface equation.

The post-modification worm-gear tooth surface equation is coupled with the rough surface equation and a worm-gear tooth surface profile considering rough morphology and modification is solved, thereby obtaining a discrete point set of the worm-gear tooth surface profile.

A blank is created and coordinate points of the discrete point set are inserted, to obtain a tooth surface curve; and based on the tooth surface curve, the three-dimensional digital model of the worm-gear pair considering rough morphology and modification is obtained.

S102: Propose a cross-scale meshing contact analysis method for the worm-gear pair.

A contact point and a tooth surface clearance are derived based on a tooth surface equation, and a load distribution among teeth is calculated to obtain mechanical performance of tooth contact, where the tooth surface equation includes a post-modification tooth surface equation.

At the moment when a contact point engages, assuming the coordinates of the contact point *Pₛ* in an engagement coordinate system are (*xₛ,yₛ,zₛ*), and a normal vector of the point is $\vec{{n}_{s}} \left({n}_{x}^{s}, {n}_{y}^{s}, {n}_{z}^{s}\right)$. Assuming a point *P*₀(*x*₀*,y*₀*,z*₀) along a tangent direction of the point *Pₛ,* a line *̅n̅_̅{̅f̅}̅*̅ parallel to *̅n̅ₛ̅*̅ and passing through the point *P*₀ is drawn. The line *̅n̅_̅{̅f̅}̅*̅ intersects with the two tooth surfaces at points P1 and P2 respectively. Since *̅n̅_̅{̅f̅}̅*̅ is parallel to *n̅ₛ̅,* it is obtained that:
$\frac{{x}_{0} - {x}_{s}}{{y}_{0} - {y}_{s}} = \frac{{n}_{x}^{s}}{{n}_{y}^{s}} ;$
$\frac{{x}_{0} - {x}_{s}}{{z}_{0} - {z}_{s}} = \frac{{n}_{x}^{s}}{{n}_{z}^{s}} ;$
where ${n}_{x}^{s} , {n}_{y}^{s}$*,* and ${n}_{z}^{s}$ represent components of the unit normal vector *̅n̅ₛ̅*̅ of the point *Pₛ* in the X, Y, and Z directions respectively; (*xₛ,yₛ,zₛ*) represents coordinates of the point *Pₛ* in a gear engagement coordinate system; (*x*₀,*y*₀,*z*₀) represents coordinates of the point *P*₀ in the gear engagement coordinate system.

Coordinates of the point P1 are obtained as follows: (*xₚ*(*uₚ,φₚ,θₚ*),*yₚ*(*uₚ,φₚ,θₚ*),*zₚ*(*uₚ,φₚ,θₚ*)).

Coordinates of the point P2 are divided as follows: (*x_{g}*(*u_{g},φ_{g},θ_{g}*),*y_{g}*(*u_{g},φ_{g},θ_{g}*),*z_{g}*(*u_{g},φ_{g},θ_{g}*)).

By solving a length *̅P̅*̅₁̅*̅P̅*̅₂̅ between the points P1 and P2, the tooth surface clearance of each discrete point along the tangent direction of the contact point *Pₛ* are obtained.

Thus, the tooth surface clearances of the discrete points along the tangent direction of the contact point can be successively obtained.

Under an external load FN, the elastic potential energy of each discrete point is mainly composed of bending energy, shear energy, radial compression energy, and contact energy. The stiffness of any point P on the tooth profile is solved using the Weber energy method:
$\frac{1}{{k}_{b}} = \frac{12}{EB} {{\int }_{{y}_{r}}^{{y}_{P}} \left[\left({y}_{P}-y\right)cos{α}_{P}-{r}_{P} sin\frac{{α}_{P}}{2}sin{α}_{P}\right]}^{2} \frac{dy}{{e}^{3} \left(y\right)} ;$
$\frac{1}{{k}_{n}} = \frac{1}{EB} {\int }_{{y}_{r}}^{{y}_{P}} {sin}^{2} {α}_{P} \frac{dy}{e \left(y\right)} ;$
$\frac{1}{{k}_{s}} = {C}_{s} \frac{1}{GB} {\int }_{{y}_{r}}^{{y}_{P}} {cos}^{2} {α}_{P} \frac{dy}{e \left(y\right)}$
${k}_{H} = \frac{π}{4} \frac{EB}{1 - {ν}^{2}}$
where *k_{b}* represents a bending stiffness; *kₙ* represents a radial compression stiffness; *kₛ* represents a shear stiffness; *k_{H}* represents a contact stiffness; P represents a point of application of the normal load FN, and yp represents a distance from an intersection point of a tooth profile centerline and a load action line to a gear center; y represents a distance between the gear center and any tooth profile point along the tooth profile centerline; yr represents a distance between the gear center and a root circle; rb represents a base circle radius; rp represents an action point radius; rd represents a pitch circle radius; *αₚ* represents an angle between the point P and the tooth profile centerline; e(y) represents a tooth thickness of any tooth profile point; E represents a material elastic modulus; *v* represents Poisson's ratio; B represents a tooth width; G represents a shear modulus; Cs represents a shear stress correction coefficient.

The total stiffness of any meshing position point P is:
$\frac{1}{{k}_{P}} = \frac{1}{{k}_{bp}} + \frac{1}{{k}_{sp}} + \frac{1}{{k}_{np}} + \frac{1}{{k}_{bg}} + \frac{1}{{k}_{sg}} + \frac{1}{{k}_{ng}} + \frac{1}{{k}_{H}} ;$
where *k_{P}* represents the stiffness of any meshing position point P; *k_{bp}*, *kₛₚ*, and *kₙₚ* represent the bending stiffness, shear stiffness, and radial compression stiffness of the driving gear, respectively; *k_{bg}, k_{sg},* and *k_{ng}* represent the bending stiffness, shear stiffness, and radial compression stiffness of the driven gear.

By introducing a profile position parameter *ε*, the total stiffness of any meshing position point P is expressed as follows:
${k}_{P} = {k}_{P} \left({ε}_{i}\right) ;$
where *εᵢ* represents the profile position parameter of each contact line at different driving gear rotation angles *θᵢ*.

For the definition of the profile position parameter *ε*, reference can be made to the degree of coincidence *ε_{α}.* Specifically, the definition of the degree of coincidence *ε_{α}* is a ratio of a length of an actual meshing line (AD) to a base circle pitch Pb:
${ε}_{α} = \frac{\overline{AD}}{{p}_{b}} ;$

Thus, the profile position parameter *εᵢ* for each contact line at different rotation angles *θᵢ* can be obtained as follows:
${ε}_{i} = \frac{\sqrt{{\left({X}_{Pi}-{X}_{A}\right)}^{2} + {\left({Y}_{Pi}-{Y}_{A}\right)}^{2}}}{{p}_{b}} ;$
where the subscript A represents a point A, which is an actual engagement point position; *X_{A}* and *Y_{A}* represent X and Y coordinates of the point A, respectively; P represents a contact point at a rotation angle *θᵢ*; *X_{Pi}* and *Y_{Pi}* represent X and Y coordinates of the point P, respectively; *p_{b}* represents the base circle pitch.

The load borne by each pair of gear teeth and the total applied load should satisfy the following relationship:
$R \left({ε}_{i}\right) = \frac{{F}_{k} \left({ε}_{i}\right)}{{F}_{N}} = \frac{{k}_{Pk} \left({ε}_{i}\right)}{{\sum }_{k = 1}^{z} {k}_{Pk} \left({ε}_{i}\right)} ;$
where *R*(*εᵢ*) represents a coefficient of a load distribution between teeth; k represents a pair of meshing teeth; Fk represents a load on a contact line of the pair of meshing teeth; kPk is the total stiffness of the pair of meshing teeth; FN is a total normal load; z represents the number of pairs of meshing teeth involved simultaneously.

In the contact analysis, any contact tooth surface is divided into *i* × *j* discrete points, and curvature radii of the discrete points on the tooth surface are extracted along the contact line direction to establish a simplified cylindrical model, converting tooth surface contact into loaded contact of two pairs of elastic cylinders with different curvature radii. According to the specific distribution of tooth surface loads, each pair of cylinders is loaded to obtain the load distribution of the discrete points.

From differential geometry, it is known that when the unit normal vector *̅n̅ₛ̅*̅ at a specific meshing point on the tooth surface is determined, principal curvatures *ρ*₁ of the points on the tooth surface of the driving gear are obtained by the following equation:
$\left|\begin{matrix}L - {ρ}_{1} E & M - {ρ}_{1} F \\ M - {ρ}_{1} F & N - {ρ}_{1} G\end{matrix}\right| = 0 ;$
where E, F, and G represent first fundamental quantities of the tooth surface; L, M, and N represent second fundamental quantities of the tooth surface.

*E = r̅ᵤ̅·r̅ᵥ̅, F* = *r̅ᵤ̅·r̅ᵥ̅*, *G = r̅ᵥ̅·r̅ᵥ̅*, *L = r̅ᵤ̅ᵤ̅·n̅ₛ̅*, *M = r̅ᵤ̅ᵥ̅·n̅ₛ̅*, and *N* = *r̅ᵥ̅ᵥ̅·n̅ₛ̅*; *̅r̅ᵤ̅*̅,*̅r̅ᵥ̅*̅,*̅r̅ᵤ̅ᵤ̅*̅,*̅r̅ᵤ̅ᵥ̅*̅,*̅r̅ᵥ̅ᵥ̅*̅ represent the first-order derivatives and second-order derivatives of the tooth surface equation with respect to parameters u and v.

The conjugate curvature radii of the two tooth surfaces in the engagement coordinate system satisfy the relationship:
$\frac{1}{{ρ}_{1} - r} + \frac{1}{{ρ}_{2} - r} = \left(\frac{1}{{r}_{1}}+\frac{1}{{r}_{2}}\right) \frac{1}{sin α} ;$
where r represents a distance between M and P; *r*₁ and *r*₂ represent pitch circle radii of the driving gear and drive gear, respectively; *α* represents a pressure angle; *ρ*₁ and *ρ*₂ represent curvature radii of point M on driving gear and driven gear profiles, respectively.

According to the specific distribution of tooth surface loads, each pair of cylinders is loaded. A ratio of the contact area length to the base circle radius is the rotation angle *θ* of the driving gear. Taking the contact of the gears in the first double-tooth meshing zone as an example, a simplified model of the model consists of two pairs of elastic cylinders with different curvature radii subjected to contact under loads. Specifically, the load borne by each discrete point is as follows:
${f}_{nij} = {F}_{nj} * R \left({ε}_{ni}\right) * P \left(n=a,b\right) ;$
${\sum }_{\begin{matrix}l = 1 … i \\ m = 1 … j \\ n = a , b\end{matrix}} {f}_{nlm} = P$
where *P* represents a total load; *n=a,b*, representing two contact points; *i* represents the *i*-th contact line at the rotation angle *θᵢ* of the driving gear; *j* represents the *j*-th discrete point in the contact line direction; *fₙᵢⱼ* represents the load on the *j*-th discrete point on the *i*-th contact line; *Fₙⱼ* represents a tooth load distribution coefficient; *R*(*εₙᵢ*) represents a load distribution coefficient between teeth.

Based on the representation of the rough surface, according to Greenwood and Tripp's contact pressure theory, the contact pressure equation for surface asperities is as follows:
${p}_{c} = \frac{16 \sqrt{2}}{15} π {\left(ηβσ\right)}^{2} E ′ \sqrt{\frac{σ}{β}} {F}_{\frac{5}{2}} \left(H\right) ;$
where *η* represents a roughness peak density, *β* represents a radius of curvature of a peak element, *E'* represents a composite elastic modulus, and H represents a film thickness ratio. According to Greenwood and Tripp's experiments, the value of *ηβσ* is a constant between 0.03 and 0.05. ${F}_{\frac{5}{2}} \left(H\right)$ is a statistical formula, which can be determined by the following fitting formula:
${F}_{\frac{5}{2}} \left(H\right) = \left\{\begin{matrix}2.134 \times {10}^{- 4} exp \left\{3.083log\left(4-H\right)+1.34\left[log{\left(4-H\right)}^{2}\right]\right\} , H \leq 3.5 \\ 1.12 \times {10}^{- 4} {\left(4-H\right)}^{1.9447} , 3.5 < H < 4 \\ 0 , H > 4\end{matrix}\right. .$

S103: For operating conditions such as determined lubricant viscosity and relative motion speed, establish a three-dimensional contact thermal elastohydrodynamic lubrication model for the worm-gear pair considering macro morphology, tooth surface roughness, and waviness of the modification tooth surface, and solve the model to obtain a friction coefficient, an oil film thickness, an oil film pressure, and a friction force.

The specific method for establishing the three-dimensional contact thermal elastohydrodynamic lubrication model for the worm-gear pair considering macro morphology, tooth surface roughness, and waviness of the modification tooth surface includes: based on the elastohydrodynamic lubrication theory and Hertz contact theory, establishing the three-dimensional thermal elastohydrodynamic lubrication model for the worm-gear pair considering the aforementioned factors, and performing thermal elastohydrodynamic lubrication analysis. The relevant formulas for the thermal elastohydrodynamic lubrication model are as follows:
Average Reynolds equation:
   $\frac{\partial }{\partial x} \left({∅}_{x}\frac{{h}^{3}}{12 μ}\frac{\partial \overline{p}}{\partial x}\right) + \frac{\partial }{\partial y} \left({∅}_{y}\frac{{h}^{3}}{12 μ}\frac{\partial \overline{p}}{\partial y}\right) = \frac{u}{2} {∅}_{c} \frac{\partial h}{\partial x} + \frac{u}{2} σ \frac{\partial {∅}_{s}}{\partial x}$, where *p̅* represents an average oil film pressure, *µ* represents a lubricating oil viscosity, *h* represents the oil film thickness, *u* represents an entrainment velocity, ∅*ₓ* represents a pressure flow factor in an x-direction, ∅*_{y}* represents a pressure flow factor in a y-direction, ∅*_{c}* represents a contact factor, and ∅*ₛ* represents a shear flow factor.
Oil film thickness equation *h*(*x, y*)*:*
   $h \left(x, y\right) = {h}_{0} + \frac{{x}^{2}}{2 {R}_{x}} + \frac{{y}^{2}}{2 {R}_{y}} + δ \left(x, y\right) + ν \left(x, y\right)$, where *Rₓ* and *R_{y}* represent equivalent radii of curvature, *E*' represents an equivalent elastic modulus, *h*₀ represents a constant that includes a membrane thickness at a rigid body center and a to-be-determined constant C, *δ*(*x, y*) represents equivalent roughness of two surfaces, and *v*(*x, y*) represents an elastic deformation.
Lubricating oil viscosity equation :
   *µ* = *η*₀ exp{(ln *η*₀ *+* 9.67)[(1 + 5.1×10⁻⁹*p*)*^{z}* -1]}, where *η*₀ represents a viscosity at atmospheric pressure, *z* represents a constant, $z = \frac{α}{5.1 \times {10}^{- 9} \left({lnη}_{0}+9.67\right)}$, and *α* represents a viscosity-pressure coefficient.
Lubricating oil density equation *ρ*:
   $ρ = {ρ}_{0} \left(1+\frac{0.6 \times {10}^{- 9} p}{1 + 1.7 \times {10}^{- 9} p}\right)$, where *ρ*₀ represents a density at atmospheric pressure and temperature *T*₀.
Load balance equation *W*:
   *W =* ∬_{Ω}[*p*(*x, y*) *+ p_{c}*(*x, y*))]*dxdy*, where *p*(*x, y*) represents load per unit area on a lubricating film, *p_{c}*(*x, y*) represents load per unit area on surface asperities, and Ω represents an integration domain.
Entrainment velocity *v*:
   $ν = \frac{{ν}_{1 n} + {ν}_{2 n}}{2}$, where *v*_{1*n*} represents a component of a worm meshing point velocity along a normal direction to a contact line, and *v*_{2*n*} represents a component of a worm gear meshing point velocity along the normal direction to the contact line.
Thermal correction coefficient *c_{T}* for the oil film thickness:
   ${c}_{T} = \frac{3.94}{3.94 + {L}^{0.62}} , L = \frac{{η}_{0} {βu}^{2}}{k}$, where *k* represents a thermal conductivity of the lubricating oil, and *β* represents a viscosity-temperature coefficient.

Based on the coupled differential deflection method and the multigrid method, the thermal elastohydrodynamic lubrication model is solved to obtain the friction coefficient, oil film thickness, oil film pressure, and friction force.

S104: With the friction coefficient, oil film thickness, oil film pressure, and friction force as objectives, propose a multi-objective optimization method based on a uniform non-dominated sorting genetic algorithm, determine an optimal worm-gear modification curve, worm tooth thickness distribution, pressure angle, helix angle, tooth surface roughness, and waviness for the hydrodynamic oil film based on an improved non-dominated sorting genetic algorithm II (NSGA-II) and principal component analysis (PCA).

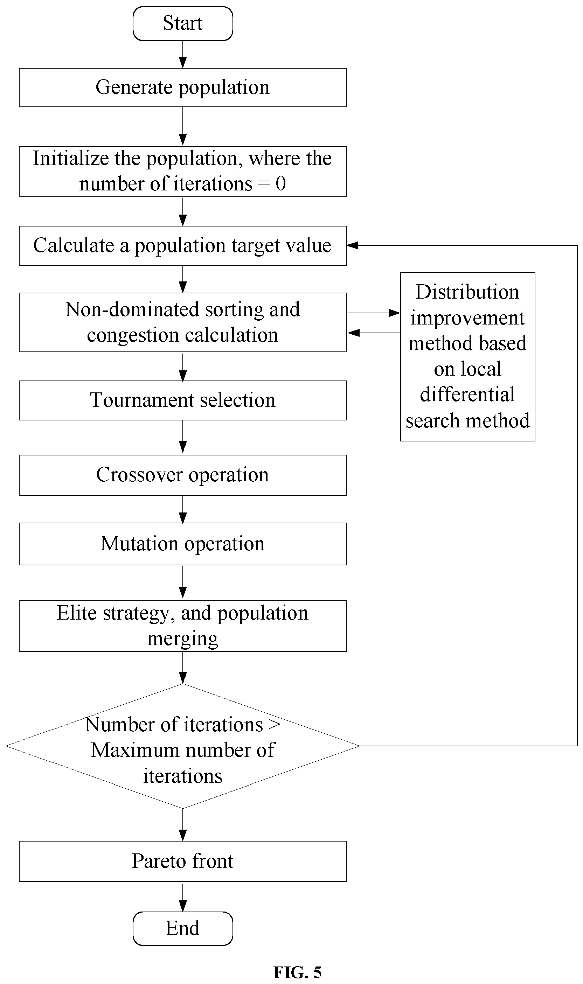

To enhance the lubrication performance of the dynamic pressure oil film, multi-objective optimization needs to be performed to improve the friction coefficient, oil film thickness, oil film pressure, and friction force. When the number of optimization objectives is not less than 3 (the present invention requires optimizing 4 objectives), existing multi-objective optimization methods (such as NSGA-II) may lead to uneven distribution of non-dominated solution sets. The present invention proposes improving the search performance of NSGA-II using a local differential search method based on differential evolution, to achieve a more uniform distribution of the Pareto front during multi-objective optimization (with no less than 3 objectives). The specific process is shown in FIG. 5.

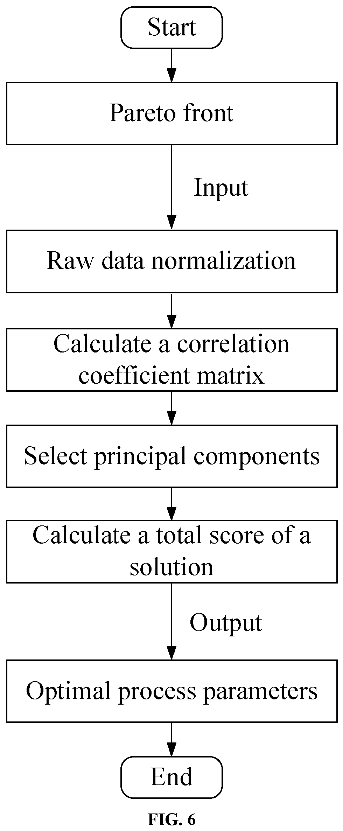

After obtaining the Pareto front containing multiple non-dominated solutions, an optimal parameter combination is automatically determined using the principal component analysis (PCA), replacing manual decision-making by experienced engineers. During the parameter decision-making process using PCA, based on the maximum variance criterion of solution distribution in the Pareto front, i.e., the dispersion of candidate solutions in the Pareto front is good, the objective weights for each solution in the Pareto front are determined. This criterion enables PCA to objectively determine the weights of each objective automatically. The specific steps are shown in FIG. 6. In determining weights of objective values using the principal component analysis, the raw objective values are first normalized using the following formula:
${x}_{i} \left(t\right) = \left({x}_{i}\left(t\right)-{x}_{min}\right) / \left({x}_{min}-{x}_{max}\right) , i = 1 , 2 , … , N ;$
where *x*ₘₐₓ and *x*ₘᵢₙ are maximum and minimum values of the objective, respectively; *xᵢ(t)* takes values between 0 and 1; and *N* is the number of solutions in the Pareto front.

When weights are assigned to the objectives using principal component analysis, essentially *q* original objective vectors are converted into *q_{ind}* linearly independent objective vectors. The objective vectors consist of linear combinations of the original objective vectors. Then, a coefficient matrix of each objective is computed to obtain a unit objective vector and a corresponding eigenvalue *λᵢ*, which are the coefficient vector and weight of the i-th principal component, respectively. All *λᵢ* values are sorted in descending order and the top *K* components are selected as principal components. A variance contribution rate (*αᵢ*) of the principal components is calculated by using the following formula. The larger the value of *αᵢ*, the stronger the ability of the principal component to integrate the original objective.
${α}_{i} = \frac{{γ}_{i}}{{\sum }_{{q}_{ind} = 1}^{K} {λ}_{i}} .$

A cumulative contribution rate of the top K principal components is calculated using the following formula.
$η = {\sum }_{{q}_{ind} = 1}^{K} {α}_{i} ;$
where *K*≤*q_{ind}*; when the cumulative contribution rate *η* reaches a specific value (which is usually set to 90%), it is considered that the top *K* principal components can reflect all the information of the original objective values.

Based on the variance contribution rate of each principal component and the objective value vector, the final score of each solution is calculated using the following formula. The solution with the highest score in the Pareto front is determined as the optimal tooth surface parameter combination, completing the optimization design of the worm-gear pair tooth surface. The optimized wedge angle of the worm gear opening ensures the formation of a dynamic pressure oil film.
${S}_{i} = {\sum }_{1}^{N} {Y}_{i} {α}_{i} ;$
where *Sᵢ* is a total score of the i-th solution; *Yᵢ* is a normalized objective value vector.

S105: Determine a hydrodynamic oil film worm-gear pair according to the optimal worm-gear modification curve, worm tooth thickness distribution, pressure angle, helix angle, tooth surface roughness, and waviness.

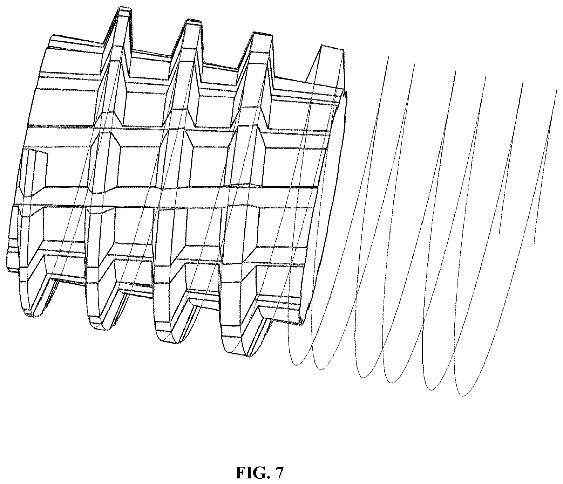

As shown in FIG. 7, the present invention further provides a precise machining method for the hydrodynamic oil film worm-gear pair described above, including:
determining a dual-lead variable-tooth-thickness hob, where the dual-lead variable-tooth-thickness hob includes a base hob face helix angle *γ*₁ and a variable-thickness hob face helix angle Y2, and different hob blade thicknesses are achieved by changing the helix angle;
machining using a standard hob blade thickness position of the dual-lead variable-tooth-thickness hob on a hobbing machine: by using a standard tooth thickness position, cutting the worm-gear pair according to a standard hobbing method until a hobbing margin of a tooth surface of the worm-gear pair is only a machining allowance of a last cut; and
performing hob shifting with the dual-lead variable-tooth-thickness hob at a current radial feed position: advancing the dual-lead variable-tooth-thickness hob axially to cut using a dual-lead variable-tooth-thickness hob blade with a larger tooth thickness, where an axial shifting amount of the dual-lead variable-tooth-thickness hob is equal to a set value L;
retracting the dual-lead variable-tooth-thickness hob to a standard cutting thickness position; and
radially feeding the dual-lead variable-tooth-thickness hob to complete the last cut.

The set value L is determined based on a single-side opening amount D.

The set value L is determined using the following formula $L = \frac{Dl}{{qm}_{n} \left({tanγ}_{2}-{tanγ}_{1}\right)}$:
where *q* represents a hob pitch circle diameter factor, *mₙ* represents a normal modulus, *l* represents a minimum unit shifting amount, $l = \frac{{m}_{n} \times z \times π}{{cosγ}_{1} \times k}$, *z* represents the number of hob heads, and k represents the number of hob slots.

The method for machining a worm gear tooth surface based on the variable-tooth-thickness hob of the present invention, by changing the hob cutting position, achieves hobbing with variable-tooth-thickness blades, ensuring that the opening shape of the worm gear tooth surface is controllable, and effectively improving the tooth surface meshing performance of the worm-gear pair.

Each embodiment in the description is described in a progressive mode, each embodiment focuses on differences from other embodiments, and references can be made to each other for the same and similar parts between embodiments. Since the system disclosed in an embodiment corresponds to the method disclosed in an embodiment, the description is relatively simple, and for related contents, references can be made to the description of the method.

## Claims

1. An active determination method for a hydrodynamic oil film worm-gear pair, comprising:
establishing a precise three-dimensional digital model for a modification tooth surface of a worm-gear pair considering rough morphology;
proposing a cross-scale meshing contact analysis method for the worm-gear pair;
establishing a three-dimensional contact thermal elastohydrodynamic lubrication model for the worm-gear pair considering macro morphology, tooth surface roughness, and waviness of the modification tooth surface, and solving the three-dimensional contact thermal elastohydrodynamic lubrication model to obtain a friction coefficient, an oil film thickness, an oil film pressure, and a friction force;
with the friction coefficient, oil film thickness, oil film pressure, and friction force as objectives, determining an optimal worm-gear modification curve, worm tooth thickness distribution, pressure angle, helix angle, tooth surface roughness, and waviness for the hydrodynamic oil film; and
determining a hydrodynamic oil film worm-gear pair according to the optimal worm-gear modification curve, worm tooth thickness distribution, pressure angle, helix angle, tooth surface roughness, and waviness;
wherein said establishing the precise three-dimensional digital model for the modification tooth surface of the worm-gear pair considering rough morphology specifically comprises:
establishing a spatial coordinate system for an enveloping process of the worm-gear pair based on a principle of conjugate surface spatial meshing, deriving a worm tooth surface equation by using kinematic concepts and coordinate transformations, and deriving a worm gear tooth profile by using a point vector enveloping method, thereby obtaining a worm-gear tooth surface equation;
determining a probability density function by treating a rough surface as a random process and using an autocorrelation function in an exponential form; and based on the probability density function, representing a rough surface of the worm-gear pair using an amplitude and a phase angle component, to obtain a rough surface equation;
performing profile modification and axial modification based on the worm-gear tooth surface equation, to obtain a post-modification worm-gear tooth surface equation; and
obtaining a three-dimensional digital model of the worm-gear pair based on the post-modification worm-gear tooth surface equation and the rough surface equation;
**characterized in that**
said determining the optimal worm-gear modification curve, worm tooth thickness distribution, pressure angle, helix angle, tooth surface roughness, and waviness for the hydrodynamic oil film is based on an improved non-dominated sorting genetic algorithm II (NSGA-II) and principal component analysis (PCA), and **in that**
said performing profile modification and axial modification based on the worm-gear tooth surface equation to obtain the post-modification worm-gear tooth surface equation specifically comprises:
determining a maximum modification amount by using the following formula: ${δ}_{Parabolic} = {Δ}_{max} {\left(\frac{x}{L}\right)}^{2}$, wherein *δ*_{Parabolic} represents a parabolic modification curve; Δₘₐₓ represents the maximum modification amount; *L* represents a total length of a double-tooth meshing zone; and *x* represents a distance from any point in the double-tooth meshing zone on a meshing line to a point of alternation between single and double teeth;
determining an inward offset of a tooth surface point after the axial modification compared to before the axial modification by using the following formula: ${e}_{M} = {r}_{c} - \sqrt{{r}_{c}^{2} - {\left({z}_{M}-Δe\right)}^{2}}$, wherein *e_{M}* is an inward offset before the axial modification; *r_{c}* is an addendum radius for involute teeth, and ${r}_{c} = \frac{{\left(0.5B\right)}^{2} + {{C}_{max}}^{2}}{2 {C}_{max}}$*; z_{M}* represents coordinates along a Z-axis direction for discrete points; Δ*e* is a deviation value between a midpoint of an addendum circle and a center of a gear; B is a tooth width; and *C*ₘₐₓ is a maximum addendum amount; and
determining the post-modification worm-gear tooth surface equation by using the following formula: $\vec{{r}_{fk}^{c}} = \left\{\begin{matrix}{{x}_{k}}^{c} \left({u}_{k}, {φ}_{k}\right) \\ {{y}_{k}}^{c} \left({u}_{k}, {φ}_{k}\right) \\ {{z}_{k}}^{c} \left({u}_{k}, {φ}_{k}\right) \\ 1\end{matrix}\right\} = \left\{\begin{matrix}{x}_{k} \left({u}_{k}, {φ}_{k}\right) + {e}_{MP} ⋅ cos \left({φ}_{{M}_{k}}\right) \\ {y}_{k} \left({u}_{k}, {φ}_{k}\right) + {e}_{MP} ⋅ sin \left({φ}_{{M}_{k}}\right) \\ {z}_{k} \left({u}_{k}, {φ}_{k}\right) \\ 1\end{matrix}\right\}$, wherein $\vec{{r}_{fk}^{c}}$ represents the post-modification tooth surface equation; *xₖ^{c}*, *yₖ^{c},* and *zₖ^{c}* represent x, y, and z coordinates of a post-modification tooth surface; *xₖ, yₖ,* and *zₖ* represent x, y, and z coordinates of a pre-modification tooth surface; *uₖ* represents an axial parameter of a tooth surface; *φₖ* represents an involute parameter during machining rotation; *e_{Mp}* represents an offset; and *φ_{Mk}* represents an angle of expansion of a tooth surface point;
wherein said obtaining the three-dimensional digital model of the worm-gear pair based on the post-modification worm-gear tooth surface equation and the rough surface equation specifically comprises:
coupling the post-modification worm-gear tooth surface equation with the rough surface equation and solving a worm-gear tooth surface profile considering rough morphology and modification, thereby obtaining a discrete point set of the worm-gear tooth surface profile; and
creating a blank and inserting coordinate points of the discrete point set, to obtain a tooth surface curve; and based on the tooth surface curve, obtaining the three-dimensional digital model of the worm-gear pair considering rough morphology and modification;
wherein said proposing the cross-scale meshing contact analysis method for the worm-gear pair specifically comprises:
deriving a contact point and a tooth surface clearance based on a tooth surface equation, and calculating a load distribution among teeth to obtain mechanical performance of tooth contact, wherein the tooth surface equation comprises a post-modification tooth surface equation;
wherein said establishing the three-dimensional contact thermal elastohydrodynamic lubrication model for the worm-gear pair considering macro morphology, tooth surface roughness, and waviness of the modification tooth surface, and solving the model to obtain the friction coefficient, oil film thickness, oil film pressure, and friction force specifically comprises:
an average Reynolds equation: $\frac{\partial }{\partial x} \left({∅}_{x}\frac{{h}^{3}}{12 μ}\frac{\partial \overline{p}}{\partial x}\right) + \frac{\partial }{\partial y} \left({∅}_{y}\frac{{h}^{3}}{12 μ}\frac{\partial \overline{p}}{\partial y}\right) = \frac{u}{2} {∅}_{c} \frac{\partial h}{\partial x} + \frac{u}{2} σ \frac{\partial {∅}_{s}}{\partial x} ,$ wherein *p̅* represents an average oil film pressure, *µ* represents a lubricating oil viscosity, *h* represents the oil film thickness, *u* represents an entrainment velocity, ∅*ₓ* represents a pressure flow factor in an x-direction, ∅*_{y}* represents a pressure flow factor in a y-direction, ∅*_{c}* represents a contact factor, and ∅*ₛ* represents a shear flow factor;
an oil film thickness equation *h*(*x, y*): $h \left(x, y\right) = {h}_{0} + \frac{{x}^{2}}{2 {R}_{x}} + \frac{{y}^{2}}{2 {R}_{y}} + δ \left(x, y\right) + ν \left(x, y\right) ,$ wherein *Rₓ* and *R_{y}* represent equivalent radii of curvature, *E*' represents an equivalent elastic modulus, *h*₀ represents a constant that includes a membrane thickness at a rigid body center and a to-be-determined constant C, *δ*(*x, y*) represents equivalent roughness of two surfaces, and *v*(*x, y*) represents an elastic deformation;
a lubricating oil viscosity equation *µ*: $μ = {η}_{0} exp \left\{\left({lnη}_{0}+9.67\right)\left[{\left(1+5.1\times {10}^{- 9}p\right)}^{z}-1\right]\right\} ,$ wherein *η*₀ represents a viscosity at atmospheric pressure, *z* represents a constant, $z = \frac{α}{5.1 \times {10}^{- 9} \left(ln {η}_{0}+9.67\right)}$, and *α* represents a viscosity-pressure coefficient;
a lubricating oil density equation *ρ*: $ρ = {ρ}_{0} \left(1+\frac{0.6 \times {10}^{- 9} p}{1 + 1.7 \times {10}^{- 9} p}\right) ,$ **wherein** ρ₀ represents a density at atmospheric pressure and temperature *T*₀;
a load balance equation *W*: $W = {∬}_{Ω} \left[p\left(x, y\right)+{p}_{c}\left.\left(x, y\right)\right)\right] dxdy ,$ wherein *p*(*x, y*) represents load per unit area on a lubricating film, *p_{c}*(*x, y*) represents load per unit area on surface asperities, and Ω represents an integration domain;
an entrainment velocity *v*: $ν = \frac{{ν}_{1 n} + {ν}_{2 n}}{2} ,$ wherein *v*_{1*n*} represents a component of a worm meshing point velocity along a normal direction to a contact line, and *v*_{2*n*} represents a component of a worm gear meshing point velocity along the normal direction to the contact line; and
a thermal correction coefficient *c_{T}* for the oil film thickness: ${c}_{T} = \frac{3.94}{3.94 + {L}^{0.62}} , L = \frac{{η}_{0} {βu}^{2}}{k} ,$ wherein *k* represents a thermal conductivity of the lubricating oil, and *β* represents a viscosity-temperature coefficient.

2. A precision machining method for a hydrodynamic oil film worm-gear pair, which is determined with
the active determination method for a hydrodynamic oil film worm-gear pair according to claim 1 and implements precision machining of a worm gear tooth surface by using a double-lead variable-tooth-thickness hob, and specifically comprising:
determining a dual-lead variable-tooth-thickness hob, wherein the dual-lead variable-tooth-thickness hob comprises a base hob face helix angle *γ*₁ and a variable-thickness hob face helix angle *γ*₂, and different hob blade thicknesses are achieved by changing the helix angle;
machining using a standard hob blade thickness position of the dual-lead variable-tooth-thickness hob on a hobbing machine: by using a standard tooth thickness position, cutting the worm-gear pair according to a standard hobbing method until a hobbing margin of a tooth surface of the worm-gear pair is only a machining allowance of a last cut;
performing hob shifting with the dual-lead variable-tooth-thickness hob at a current radial feed position: advancing the dual-lead variable-tooth-thickness hob axially to cut using a dual-lead variable-tooth-thickness hob blade with a larger tooth thickness, wherein an axial shifting amount of the dual-lead variable-tooth-thickness hob is equal to a set value L;
retracting the dual-lead variable-tooth-thickness hob to a standard cutting thickness position; and
radially feeding the dual-lead variable-tooth-thickness hob to complete the last cut.

3. The precision machining method for a hydrodynamic oil film worm-gear pair according to claim 2, wherein the set value L is determined based on a single-side opening amount D;
wherein the set value L is determined using the following formula: $L = \frac{Dl}{{qm}_{n} \left({tanγ}_{2}-{tanγ}_{1}\right)}$;
wherein *q* represents a hob pitch circle diameter factor, *mₙ* represents a normal modulus, *l* represents a minimum unit shifting amount, $l = \frac{{m}_{n} \times z \times π}{{cosγ}_{1} \times k}$*, z* represents the number of hob heads, and k represents the number of hob slots.

## Patentansprüche

1. Verfahren zur aktiven Bestimmung eines hydrodynamischen Ölfilm-Schneckengetriebepaares, umfassend:
Erstellen eines präzisen dreidimensionalen digitalen Modells für eine modifizierte Zahnoberfläche eines Schneckengetriebepaares unter Berücksichtigung der Zahnoberflächenrauheit;
Vorschlagen eines skalierungsübergreifenden Kontaktanalysemodells für das Schneckengetriebepaar;
Erstellen eines dreidimensionalen thermisch-elastohydrodynamischen Schmiermodells für das Schneckengetriebepaar unter Berücksichtigung der Makromorphologie, der Zahnoberflächenrauheit und der Welligkeit der modifizierten Zahnoberfläche sowie Lösen des dreidimensionalen thermisch-elastohydrodynamischen Schmiermodells, um einen Reibungskoeffizienten, eine Ölfilmdicke, einen Ölfilmdruck und eine Reibungskraft zu erhalten;
Bestimmen einer optimalen Modifikationskurve für das Schneckengetriebepaar unter Verwendung des Reibungskoeffizienten, der Ölfilmdicke, des Ölfilmdrucks und der Reibungskraft als Zielgrößen, der Zahnstärkenverteilung der Schneckenzähne, des Druckwinkels, des Steigungswinkels, der Zahnoberflächenrauheit und der Welligkeit für den hydrodynamischen Ölfilm; und
Bestimmen eines hydrodynamischen Ölfilm-Schneckengetriebepaares gemäß der optimalen Modifikationskurve des Schneckengetriebes, der Zahnstärkenverteilung, des Druckwinkels, des Steigungswinkels, der Zahnoberflächenrauheit und der Welligkeit;
wobei das Erstellen des präzisen dreidimensionalen digitalen Modells für die modifizierte Zahnoberfläche des Schneckengetriebepaares unter Berücksichtigung der Zahnoberflächenrauheit konkret umfasst:
Erstellen eines räumlichen Koordinatensystems für ein Hüllverfahren des Schneckengetriebepaares auf der Grundlage eines Prinzips der räumlichen Vernetzung konjugierter Flächen, Ableiten einer Zahnoberflächengleichung unter Verwendung kinematischer Konzepte und Koordinatentransformationen sowie Ableiten eines Schneckenzahnprofils unter Verwendung eines Punktvektor-Hüllverfahrens, wodurch die Zahnoberflächengleichung erhalten wird;
Bestimmen einer Wahrscheinlichkeitsdichtefunktion durch Behandlung einer rauen Oberfläche als Zufallsprozess und Verwendung einer Autokorrelationsfunktion in exponentieller Form; und auf der Grundlage der Wahrscheinlichkeitsdichtefunktion Darstellen einer rauen Oberfläche des Schneckengetriebepaares unter Verwendung einer Amplituden- und einer Phasenwinkelkomponente, um eine Rauheitsgleichung zu erhalten;
Durchführen einer Profilmodifikation und einer axialen Modifikation auf der Grundlage der Zahnoberflächengleichung des Schneckengetriebes, um eine modifizierte Zahnoberflächengleichung des Schneckengetriebes zu erhalten; und
Erstellen eines dreidimensionalen digitalen Modells des Schneckengetriebepaares auf der Grundlage der modifizierten Zahnoberflächengleichung des Schneckengetriebes und der Rauheitsgleichung;
**dadurch gekennzeichnet, dass**
das Bestimmen der optimalen Modifikationskurve des Schneckengetriebes, der Zahnstärkenverteilung, des Druckwinkels, des Steigungswinkels, der Zahnoberflächenrauheit und der Welligkeit für den hydrodynamischen Ölfilm auf einem verbesserten nicht-dominierten genetischen Sortieralgorithmus II (NSGA-II) und einer Hauptkomponentenanalyse (PCA) basiert, und dass
das Durchführen der Profilmodifikation und der axialen Modifikation auf der Grundlage der Zahnoberflächengleichung des Schneckengetriebes, um die modifizierte Zahnoberflächengleichung des Schneckengetriebes zu erhalten, insbesondere umfasst:
Bestimmen eines maximalen Modifikationsbetrags unter Verwendung der folgenden Formel: ${δ}_{Parabolic} = {Δ}_{max} {\left(\frac{x}{L}\right)}^{2} ,$ wobei *δ*_{Parabolic} eine parabolische Modifikationskurve darstellt;
Δₘₐₓ den maximalen Modifikationsbetrag darstellt; *L* die Gesamtlänge einer Doppelzahn-Eingriffszone darstellt; und *x* einen Abstand von einem beliebigen Punkt in der Doppelzahn-Eingriffszone auf einer Eingriffslinie zu einem Wechselpunkt zwischen Einzel- und Doppelzähnen darstellt;
Bestimmen eines Einwärtsversatzes eines Zahnoberflächenpunkts nach der axialen Modifikation im Vergleich zu vor der axialen Modifikation unter Verwendung der folgenden Formel: ${e}_{M} = {r}_{c} - \sqrt{{r}_{c}^{2} - {\left({z}_{M}-Δe\right)}^{2}} ,$ wobei *e_{M}* ein Einwärtsversatz vor der axialen Modifikation ist; *r_{c}* ein Addendumradius für Evolventenzähne ist und ${r}_{c} = \frac{{\left(0.5B\right)}^{2} + {{C}_{max}}^{2}}{2 {C}_{max}}$*; z_{M}* Koordinaten entlang einer Z-Achsenrichtung für diskrete Punkte darstellt; Δ*e* ein Abweichungswert zwischen einem Mittelpunkt eines Addendumkreises und einem Zentrum eines Zahnrads ist; B eine Zahnbreite ist; und *C*ₘₐₓ ein maximaler Addendum-Wert ist; und
Bestimmen der modifizierten Zahnoberflächengleichung des Schneckengetriebes unter Verwendung der folgenden Formel: $\vec{{r}_{fk}^{c}} = \left\{\begin{matrix}{x}_{k}^{c} \left({u}_{k}, {φ}_{k}\right) \\ {y}_{k}^{c} \left({u}_{k}, {φ}_{k}\right) \\ {z}_{k}^{c} \left({u}_{k}, {φ}_{k}\right) \\ 1\end{matrix}\right\} = \left\{\begin{matrix}{x}_{k} \left({u}_{k}, {φ}_{k}\right) + {e}_{MP} ⋅ cos \left({φ}_{{M}_{k}}\right) \\ {y}_{k} \left({u}_{k}, {φ}_{k}\right) + {e}_{MP} ⋅ sin \left({φ}_{{M}_{k}}\right) \\ {z}_{k} \left({u}_{k}, {φ}_{k}\right) \\ 1\end{matrix}\right\}$, wobei $\vec{{r}_{fk}^{c}}$ die modifizierte Zahnoberflächengleichung darstellt; *xₖ^{c}*, *yₖ^{c},* und *zₖ^{c}* die x-, y- und z-Koordinaten einer Zahnoberfläche nach der Modifikation darstellen; *xₖ, yₖ,* und *zₖ* die x-, y- und z-Koordinaten einer Zahnoberfläche vor der Modifikation darstellen; *uₖ* einen axialen Parameter einer Zahnoberfläche darstellt; *φₖ* einen Evolventenparameter während der Bearbeitungsrotation darstellt;
*e_{Mp}* einen Versatz darstellt; und *φ_{Mk}* einen Expansionswinkel eines Zahnoberflächenpunkts darstellt; wobei das Erhalten des dreidimensionalen digitalen Modells des Schneckengetriebepaares auf der Grundlage der modifizierten Zahnoberflächengleichung des Schneckenrads und der Rauheitsgleichung konkret umfasst:
Koppeln der modifizierten Zahnoberflächengleichung des Schneckengetriebes mit der Rauheitsgleichung und Lösen eines Zahnoberflächenprofils des Schneckengetriebes unter Berücksichtigung der Makromorphologie und der Modifikation, wodurch ein diskreter Punktesatz des Zahnoberflächenprofils des Schneckengetriebes erhalten wird; und
Erstellen eines Rohteils und Einfügen von Koordinatenpunkten des diskreten Punktesatzes, um eine Zahnoberflächenkurve zu erhalten; und auf der Grundlage der Zahnoberflächenkurve Erhalten des dreidimensionalen digitalen Modells des Schneckengetriebepaars unter Berücksichtigung der Makromorphologie und der Modifikation;
wobei das Vorschlagen des skalierungsübergreifenden Kontaktanalysemodells für das Schneckengetriebepaar konkret umfasst:
Ableiten eines Kontaktpunkts und eines Zahnoberflächenabstands auf der Grundlage einer Zahnoberflächengleichung sowie Berechnen einer Lastverteilung zwischen den Zähnen, um die mechanische Leistung des Zahnkontakts zu erhalten, wobei die Zahnoberflächengleichung eine modifizierte Zahnoberflächengleichung umfasst;
wobei das Erstellen des dreidimensionalen thermisch-elastohydrodynamischen Schmiermodells für das Schneckengetriebepaar unter Berücksichtigung der Makromorphologie, der Zahnoberflächenrauheit und der Welligkeit der modifizierten Zahnoberfläche sowie das Lösen des Modells zur Ermittlung des Reibungskoeffizienten, der Ölfilmdicke, des Ölfilmdrucks und der Reibungskraft konkret umfasst:
eine durchschnittliche Reynolds-Gleichung: $\frac{\partial }{\partial x} \left({∅}_{x}\frac{{h}^{3}}{12 μ}\frac{\partial \overline{p}}{\partial x}\right) + \frac{\partial }{\partial y} \left({∅}_{y}\frac{{h}^{3}}{12 μ}\frac{\partial \overline{p}}{\partial y}\right) = \frac{u}{2} {∅}_{c} \frac{\partial h}{\partial x} + \frac{u}{2} σ \frac{\partial {∅}_{s}}{\partial x} ,$ wobei *p̅* den mittleren Ölfilmdruck, *µ* die Schmierölviskosität, *h* die Ölfilmdicke, *u* die Mitreißgeschwindigkeit, ∅*ₓ* den Druckströmungsfaktor in x-Richtung, ∅*_{y}* den Druckströmungsfaktor in y-Richtung, ∅*_{c}* den Kontaktfaktor, und ∅*ₛ* den Scherströmungsfaktor darstellen,
eine Ölfilmdicken-Gleichung *h*(*x, y*): $h \left(x, y\right) = {h}_{0} + \frac{{x}^{2}}{2 {R}_{x}} + \frac{{y}^{2}}{2 {R}_{y}} + δ \left(x, y\right) + ν \left(x, y\right) ,$ wobei *Rₓ* und *R_{y}* äquivalente Krümmungsradien darstellen, *E*' einen äquivalenten Elastizitätsmodul darstellt, *h*₀ eine Konstante darstellt, die eine Membrandicke am Zentrum eines starren Körpers und eine zu bestimmende Konstante C umfasst, *δ*(*x*, *y*) die äquivalente Rauheit zweier Oberflächen darstellt, und *v*(*x, y*) eine elastische Verformung darstellt;
eine Schmierölviskositätsgleichung *µ*: $μ = {η}_{0} exp \left\{\left({lnη}_{0}+9.67\right)\left[{\left(1+5.1\times {10}^{- 9}p\right)}^{z}-1\right]\right\} ,$ wobei *η*₀ eine Viskosität bei Atmosphärendruck darstellt, *z* eine Konstante darstellt, $z = \frac{α}{5.1 \times {10}^{- 9} \left({lnη}_{0}+9.67\right)}$, und *α* einen Viskositäts-Druck-Koeffizienten darstellt;
eine Schmieröldichte-Gleichung *ρ*: $ρ = {ρ}_{0} \left(1+\frac{0.6 \times {10}^{- 9} p}{1 + 1.7 \times {10}^{- 9} p}\right) ,$ wobei ρ₀ eine Dichte bei Atmosphärendruck und -temperatur *T*₀ darstellt;
eine Lastbilanzgleichung *W*: $W = {∬}_{Ω} \left[p\left(x, y\right)+{p}_{c}\left.\left(x, y\right)\right)\right] dxdy ,$ wobei *p*(*x, y*) die Last pro Flächeneinheit auf einem Schmierfilm darstellt, *p_{c}*(*x, y)* die Last pro Flächeneinheit auf Oberflächenunebenheiten darstellt, und Ω einen Integrationsbereich darstellt;
eine Mitreißgeschwindigkeit *v*: $ν = \frac{{ν}_{1 n} + {ν}_{2 n}}{2} ,$ wobei *v*_{1*n*} eine Komponente der Geschwindigkeit des Schneckenverzahnungspunkts entlang einer Normalen zur Kontaktlinie darstellt, und *v*_{2*n*} eine Komponente der Geschwindigkeit des Schneckenradverzahnungspunkts entlang der Normalen zur Kontaktlinie darstellt; und
einen thermischen Korrekturfaktor *c_{T}* für die Ölfilmdicke: ${c}_{T} = \frac{3.94}{3.94 + {L}^{0.62}} , L = \frac{{η}_{0} {βu}^{2}}{k} ,$ wobei *k* die Wärmeleitfähigkeit des Schmieröls darstellt und den Viskositäts-Temperatur-Koeffizienten darstellt.

2. Präzisionsbearbeitungsverfahren für ein hydrodynamisches Ölfilm-Schneckengetriebepaar, das mit dem aktiven Bestimmungsverfahren für ein hydrodynamisches Ölfilm-Schneckengetriebepaar gemäß Anspruch 1 bestimmt wird und die Präzisionsbearbeitung einer Schneckenrad-Zahnoberfläche unter Verwendung eines Doppelgewinde-Wälzfräsers mit variabler Zahndicke durchführt, und insbesondere umfassend:
Bestimmen eines Wälzfräsers mit doppeltem Steigungswinkel und variabler Zahndicke, wobei der Wälzfräser mit doppeltem Steigungswinkel und variabler Zahndicke einen Grund-Wälzfräser-Spiralwinkel *γ*₁ und einen Wälzfräser-Spiralwinkel ***γ*₂** mit variabler Zahndicke aufweist, und unterschiedliche Wälzfräser-Zahndicken durch Änderung des Spiralwinkels erzielt werden;
Bearbeiten unter Verwendung einer Standard-Schnittdickenposition des Doppelgewinde-Wälzfräsers mit variabler Zahndicke auf einer Wälzfräsmaschine, wobei das Schneckengetriebepaar unter Verwendung einer Standard-Zahndickenposition nach einem Standard-Wälzfräsverfahren bearbeitet wird, bis der Wälzfräserrand einer Zahnoberfläche des Schneckengetriebepaares nur noch eine Bearbeitungszugabe eines letzten Schnitts beträgt;
Durchführen einer Wälzfräser-Verschiebung mit dem Wälzfräser mit variabler Zahndicke und doppeltem Steigungswinkel an einer aktuellen radialen Vorschubposition;
axiales Vorschieben des Wälzfräsers mit variabler Zahndicke und doppeltem Steigungswinkel, um mit einer Wälzfräserklinge mit variabler Zahndicke und doppeltem Steigungswinkel sowie größerer Zahndicke zu schneiden, wobei ein axialer Verschiebungsbetrag des Wälzfräsers mit variabler Zahndicke und doppeltem Steigungswinkel einem Einstellwert L entspricht;
Zurückziehen des Doppelgewinde-Wälzfräsers mit variabler Zahndicke in eine Standard-Schnittdickenposition; und
radiales Vorschieben des Doppelgewinde-Wälzfräsers mit variabler Zahndicke, um den letzten Schnitt abzuschließen.

3. Verfahren zur Präzisionsbearbeitung eines hydrodynamischen Ölfilm-Schneckengetriebepaares nach Anspruch 2, wobei der Einstellwert L auf der Grundlage eines einseitigen Öffnungsmaßes D bestimmt wird;
wobei der Einstellwert L unter Verwendung der folgenden Formel bestimmt wird: $L = \frac{Dl}{{qm}_{n} \left({tanγ}_{2}-{tanγ}_{1}\right)}$;
wobei *q* einen Wälzkreisdurchmesserfaktor des Wälzfräsers darstellt, *mₙ* einen Normalschnittmodul darstellt, *l* ein minimales Einheitsverschiebungsmaß darstellt, $l = \frac{{m}_{n} \times z \times π}{{cosγ}_{1} \times k}$*, z* die Anzahl der Wälzfräsköpfe darstellt und k die Anzahl der Wälzfräserschlitze darstellt.

## Revendications

1. Procédé de détermination active pour un couple vis sans fin/engrenage à film d'huile hydrodynamique, comprenant :
l'établissement d'un modèle numérique tridimensionnel précis pour une surface de dent modifiée d'un couple vis sans fin/engrenage en tenant compte d'une morphologie rugueuse ;
la proposition d'un procédé d'analyse du contact d'engrènement à échelles croisées pour le couple vis sans fin/engrenage ;
l'établissement d'un modèle de lubrification élastohydrodynamique thermique de contact tridimensionnel pour le couple vis sans fin/engrenage en tenant compte d'une morphologie macroscopique, d'une rugosité de surface dentée et d'une ondulation de la surface dentée modifiée, et la résolution du modèle de lubrification élastohydrodynamique thermique de contact tridimensionnel afin d'obtenir un coefficient de frottement, une épaisseur de film d'huile, une pression de film d'huile et une force de frottement ;
la détermination, avec le coefficient de frottement, l'épaisseur de film d'huile, la pression de film d'huile et la force de frottement comme objectifs, d'une courbe de modification optimale du couple vis sans fin/engrenage, d'une distribution d'épaisseur de dent de vis sans fin, d'un angle de pression, d'un angle d'hélice, d'une rugosité de surface dentée et d'une ondulation pour le film d'huile hydrodynamique ; et
la détermination d'un couple vis sans fin/engrenage à film d'huile hydrodynamique selon la courbe de modification optimale du couple vis sans fin/engrenage, la distribution d'épaisseur de dent de vis sans fin, l'angle de pression, l'angle d'hélice, la rugosité de surface dentée et l'ondulation ;
dans lequel ledit établissement du modèle numérique tridimensionnel précis pour la surface dentée modifiée du couple vis sans fin/engrenage en tenant compte de la morphologie rugueuse comprend spécifiquement :
l'établissement d'un système de coordonnées spatial pour un processus d'enveloppement du couple vis sans fin/engrenage sur la base d'un principe d'engrènement spatial de surfaces conjuguées, la déduction d'une équation de surface dentée de vis sans fin au moyen de concepts cinématiques et de transformations de coordonnées, et la déduction d'un profil de dent de l'engrenage au moyen d'un procédé d'enveloppement par vecteur de point, obtenant ainsi une équation de surface dentée du couple vis sans fin/engrenage;
la détermination d'une fonction de densité de probabilité en traitant une surface rugueuse comme un processus aléatoire et en utilisant une fonction d'autocorrélation sous une forme exponentielle ; et, sur la base de la fonction de densité de probabilité, la représentation d'une surface rugueuse du couple vis sans fin/engrenage au moyen d'une amplitude et d'une composante d'angle de phase, afin d'obtenir une équation de surface rugueuse ;
la réalisation d'une modification de profil et d'une modification axiale sur la base de l'équation de surface dentée du couple vis sans fin/engrenage, afin d'obtenir une équation de surface dentée du couple vis sans fin/engrenage après modification ; et
l'obtention d'un modèle numérique tridimensionnel du couple vis sans fin/engrenage sur la base de l'équation de surface dentée du couple vis sans fin/engrenage après modification et de l'équation de surface rugueuse ;
**caractérisé en ce que**
ladite détermination de la courbe de modification optimale du couple vis sans fin/engrenage, de la distribution d'épaisseur de dent de vis sans fin, de l'angle de pression, de l'angle d'hélice, de la rugosité de surface dentée et de l'ondulation pour le film d'huile hydrodynamique est basée sur un algorithme génétique de tri non dominé II amélioré (NSGA-II) et une analyse en composantes principales (PCA), et **en ce que**
ladite réalisation d'une modification de profil et d'une modification axiale sur la base de l'équation de surface dentée du couple vis sans fin/engrenage afin d'obtenir l'équation de surface dentée du couple vis sans fin/engrenage après modification comprend spécifiquement :
la détermination d'une quantité de modification maximale en utilisant la formule suivante : ${δ}_{Parabolique} = {Δ}_{max} {\left(\frac{x}{L}\right)}^{2}$, dans laquelle δ*_{Parabolique}* représente une courbe de modification parabolique ; Δₘₐₓ représente la quantité de modification maximale ; *L* représente une longueur totale d'une zone d'engrènement à deux dents ; et x représente une distance depuis un point quelconque dans la zone d'engrènement à deux dents sur une ligne d'engrènement jusqu'à un point d'alternance entre une dent simple et deux dents ;
la détermination d'un décalage vers l'intérieur d'un point de surface dentée après la modification axiale par rapport à avant la modification axiale en utilisant la formule suivante : ${e}_{M} = {r}_{c} - \sqrt{{r}_{c}^{2} - {\left({z}_{M}-Δe\right)}^{2}}$, dans laquelle *e_{M}* est un décalage vers l'intérieur avant la modification axiale ; *r_{c}* est un rayon de tête pour des dents développantes ; et ${r}_{c} = \frac{{\left(0.5B\right)}^{2} + {C}_{max}^{2}}{2 {C}_{max}}$; *z_{M}* représente des coordonnées suivant une direction d'axe Z pour des points discrets ; Δ*e* est une valeur d'écart entre un point médian d'un cercle de tête et un centre d'un engrenage; B est une largeur de dent ; et *Cₘₐₓ* est une quantité de saillie maximale ; et
la détermination de l'équation de surface dentée du couple vis sans fin/engrenage après modification en utilisant la formule suivante : $\vec{{r}_{fk}^{c}} \left\{\begin{matrix}{x}_{k}^{c} \left({u}_{k}, {φ}_{k}\right) \\ {y}_{k}^{c} \left({u}_{k}, {φ}_{k}\right) \\ {z}_{k}^{c} \left({u}_{k}, {φ}_{k}\right) \\ 1\end{matrix}\right\} = \left\{\begin{matrix}{x}_{k} \left({u}_{k}, {φ}_{k}\right) + {e}_{MP} ⋅ cos \left({φ}_{{M}_{k}}\right) \\ {y}_{k} \left({u}_{k}, {φ}_{k}\right) + {e}_{MP} ⋅ sin \left({φ}_{{M}_{k}}\right) \\ {z}_{k} \left({u}_{k}, {φ}_{k}\right) \\ 1\end{matrix}\right\}$ , dans laquelle $\vec{{r}_{fk}^{c}}$ représente l'équation de surface dentée après modification ; ${x}_{k}^{c} , {y}_{k}^{c}$ et ${z}_{k}^{c}$ représentent les coordonnées x, y et z d'une surface dentée après modification ; *xₖ, yₖ* et *zₖ* représentent les coordonnées x, y et z d'une surface dentée avant modification ; *uₖ* représente un paramètre axial d'une surface dentée ; *φₖ* représente un paramètre de développante pendant la rotation d'usinage ; *e_{MP}* représente un décalage ; et *φ_{Mk}* représente un angle d'expansion d'un point de surface dentée ;
dans lequel ladite obtention du modèle numérique tridimensionnel du couple vis sans fin/engrenage sur la base de l'équation de surface dentée du couple vis sans fin/engrenage après modification et de l'équation de surface rugueuse comprend spécifiquement :
le couplage de l'équation de surface dentée du couple vis sans fin/engrenage après modification avec l'équation de surface rugueuse et la résolution d'un profil de surface dentée du couple vis sans fin/engrenage en tenant compte de la morphologie rugueuse et de la modification, obtenant ainsi un ensemble de points discrets du profil de surface dentée du couple vis sans fin/engrenage ; et
la création d'une ébauche et l'insertion de points de coordonnées de l'ensemble de points discrets, afin d'obtenir une courbe de surface dentée ; et, sur la base de la courbe de surface dentée, l'obtention du modèle numérique tridimensionnel du couple vis sans fin/engrenage en tenant compte de la morphologie rugueuse et de la modification ;
dans lequel ladite proposition du procédé d'analyse du contact d'engrènement à échelles croisées pour le couple vis sans fin/engrenage comprend spécifiquement :
la déduction d'un point de contact et d'un jeu de surface dentée sur la base d'une équation de surface dentée, et le calcul d'une répartition de charge entre des dents afin d'obtenir une performance mécanique du contact de dents, dans lequel l'équation de surface dentée comprend une équation de surface dentée après modification ;
dans lequel ledit établissement du modèle de lubrification élastohydrodynamique thermique de contact tridimensionnel pour le couple vis sans fin/engrenage en tenant compte de la morphologie macroscopique, de la rugosité de surface dentée et de l'ondulation de la surface dentée modifiée, et la résolution du modèle afin d'obtenir le coefficient de frottement, l'épaisseur de film d'huile, la pression de film d'huile et la force de frottement comprennent spécifiquement :
une équation de Reynolds moyenne : $\frac{\partial }{\partial x} \left({∅}_{x}\frac{{h}^{3}}{12 μ}\frac{\partial \overline{p}}{\partial x}\right) + \frac{\partial }{\partial y} \left({∅}_{y}\frac{{h}^{3}}{12 μ}\frac{\partial \overline{p}}{\partial y}\right) = \frac{u}{2} {∅}_{c} \frac{\partial h}{\partial x} + \frac{u}{2} σ \frac{\partial {∅}_{s}}{\partial x} ,$ dans laquelle *̅p̅*̅ représente une pression moyenne de film d'huile, *µ* représente une viscosité d'huile lubrifiante, *h* représente l'épaisseur de film d'huile, *u* représente une vitesse d'entraînement, Ø*ₓ* représente un facteur d'écoulement de pression dans une direction x, Ø*_{y}* représente un facteur d'écoulement de pression dans une direction y, Ø*_{c}* représente un facteur de contact, et Ø*ₛ* représente un facteur d'écoulement de cisaillement ;
une équation d'épaisseur de film d'huile *h*(*x, y*) : $h \left(x, y\right) = {h}_{0} + \frac{{x}^{2}}{2 {R}_{x}} + \frac{{y}^{2}}{2 {R}_{y}} + δ \left(x, y\right) + ν \left(x, y\right) ,$ dans laquelle *Rₓ* et *R_{y}* représentent des rayons de courbure équivalents, *E'* représente un module d'élasticité équivalent, *h*₀ représente une constante qui comprend une épaisseur de film au centre d'un corps rigide et une constante C à déterminer, *δ*(*x, y*) représente une rugosité équivalente de deux surfaces, et *v(x, y)* représente une déformation élastique ;
une équation de viscosité d'huile lubrifiante *µ* : $μ = {η}_{0} exp \left\{\left(ln {η}_{0}+9,67\right)\left[{\left(1+5,1\times {10}^{- 9}p\right)}^{z}-1\right]\right\} ,$ dans laquelle *η*₀ représente une viscosité à la pression atmosphérique, z représente une constante, $z = \frac{α}{5 , 1 \times {10}^{- 9} \left({lnη}_{0}+9,67\right)}$, et *α* représente un coefficient viscosité-pression ;
une équation de masse volumique d'huile lubrifiante ρ : $ρ = {ρ}_{0} \left(1+\frac{0 , 6 \times {10}^{- 9} p}{1 + 1 , 7 \times {10}^{- 9} p}\right) ,$ dans laquelle *ρ*₀ représente une masse volumique à la pression atmosphérique et à la température *T*₀ ;
une équation d'équilibre de charge *W* : $W = {∬}_{Ω} \left[p\left(x, y\right)+{p}_{c}\left(x, y\right)\right] dxdy ,$ dans laquelle *p*(*x, y*) représente une charge par unité de surface sur un film lubrifiant, *p_{c}*(*x, y*) représente une charge par unité de surface sur des aspérités de surface, et Ω représente un domaine d'intégration ;
une vitesse d'entraînement *v* : $v = \frac{{v}_{1 n} + {v}_{2 n}}{2} ,$ dans laquelle *v*_{1*n*} représente une composante d'une vitesse de point d'engrènement de vis sans fin suivant une direction normale à une ligne de contact, et *v*_{2*n*} représente une composante d'une vitesse de point d'engrènement d'engrenage suivant la direction normale à la ligne de contact ; et
un coefficient de correction thermique *c_{T}* pour l'épaisseur de film d'huile : ${c}_{T} = \frac{3.94}{3.94 + {L}^{0.62}} , L = \frac{{η}_{0} β {u}^{2}}{k} ,$ dans laquelle k représente une conductivité thermique de l'huile lubrifiante, et *β* représente un coefficient viscosité-température.

2. Procédé d'usinage de précision pour un couple vis sans fin/engrenage à film d'huile hydrodynamique, qui est déterminé avec le procédé de détermination active pour un couple vis sans fin/engrenage à film d'huile hydrodynamique selon la revendication 1 et met en œuvre un usinage de précision d'une surface dentée de l'engrenage sans fin au moyen d'une fraise-mère à double pas et à épaisseur de dent variable, et comprenant spécifiquement :
la détermination d'une fraise-mère à double pas et à épaisseur de dent variable, dans laquelle la fraise-mère à double pas et à épaisseur de dent variable comprend un angle d'hélice de face de fraise-mère de base γ₁ et un angle d'hélice de face de fraise-mère à épaisseur variable γ₂, et différentes épaisseurs de lames de fraise-mère sont obtenues en changeant l'angle d'hélice ;
l'usinage en utilisant une position d'épaisseur de lame de fraise-mère standard de la fraise-mère à double pas et à épaisseur de dent variable sur une machine de taillage par fraise-mère : en utilisant une position d'épaisseur de dent standard, la coupe du couple vis sans fin/engrenage selon un procédé de taillage par fraise-mère standard jusqu'à ce qu'une surépaisseur de taillage par fraise-mère d'une surface dentée du couple vis sans fin/engrenage ne soit plus qu'une surépaisseur d'usinage d'une dernière passe ;
la réalisation d'un décalage axial de fraise-mère avec la fraise-mère à double pas et à épaisseur de dent variable à une position d'avance radiale actuelle : l'avancée axiale de la fraise-mère à double pas et à épaisseur de dent variable pour couper en utilisant une lame de fraise-mère à double pas et à épaisseur de dent variable présentant une épaisseur de dent plus grande, dans lequel une quantité de décalage axial de la fraise-mère à double pas et à épaisseur de dent variable est égale à une valeur définie L ;
le recul de la fraise-mère à double pas et à épaisseur de dent variable jusqu'à une position d'épaisseur de coupe standard ; et
l'avance radiale de la fraise-mère à double pas et à épaisseur de dent variable pour achever la dernière passe.

3. Procédé d'usinage de précision pour un couple vis sans fin/engrenage à film d'huile hydrodynamique selon la revendication 2, dans lequel la valeur définie L est déterminée sur la base d'une quantité d'ouverture d'un seul côté D ;
dans lequel la valeur définie L est déterminée en utilisant la formule suivante : $L = \frac{Dl}{{qm}_{n} \left(tan {γ}_{2}-tan {γ}_{1}\right)} ;$
dans lequel *q* représente un facteur de diamètre de cercle primitif de fraise-mère, *mₙ* représente un module normal, *l* représente une quantité de décalage minimale unitaire, $l = \frac{{m}_{n} \times z \times π}{cos {γ}_{1} \times k}$, z représente le nombre de filets de fraise-mère, et k représente le nombre de rainures de fraise-mère.
